(19)

Europäisches Patentamt
European Patent Office
Office européen des brevets

(11) **EP 1 936 665 A1**

(12) **EUROPEAN PATENT APPLICATION**
published in accordance with Art. 153(4) EPC

(43) Date of publication:
**25.06.2008 Bulletin 2008/26**

(51) Int Cl.:
***H01L 21/027*** *(2006.01)*

(21) Application number: **06810341.5**

(22) Date of filing: **20.09.2006**

(86) International application number:
**PCT/JP2006/318645**

(87) International publication number:
**WO 2007/034838 (29.03.2007 Gazette 2007/13)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **21.09.2005 JP 2005273738**
**11.11.2005 JP 2005327092**

(71) Applicant: **NIKON CORPORATION**
**Tokyo 100-8331 (JP)**

(72) Inventor: **NAGASAKA, Hiroyuki**
**Chiyoda-ku**
**Tokyo 100-8331 (JP)**

(74) Representative: **Viering, Jentschura & Partner**
**Grillparzerstrasse 14**
**81675 München (DE)**

(54) **EXPOSURE DEVICE, EXPOSURE METHOD, AND DEVICE FABRICATION METHOD**

(57)     An exposure apparatus (EX) is provided with an optical element (LS1), which has a concave surface from which an exposure light (EL) emerges, and a surface (20), which is provided so that it surrounds the optical path of the exposure light (EL). An interface (LG) of a liquid (LQ) of an immersion region (LR) is held between the surface (20) and an object (P), which is disposed at a position where it can be irradiated by the exposure light (EL).

FIG. 1

**Description**

TECHNICAL FIELD

The present invention relates to an exposure apparatus that exposes a substrate, as well as to an exposure method, and a device fabricating method.

Priority is claimed on Japanese Patent Application No. 2005-273 73 8, filed on September 21, 2005, and Japanese Patent Application No. 2005-327092, filed on November 11, 2005, the contents of which are incorporated herein by reference.

BACKGROUND ART

Among exposure apparatuses used in a photolithographic process, a liquid immersion type exposure apparatus is known that fills a space between an optical element and a substrate with a liquid and exposes the substrate through that liquid, as disclosed in the following Patent Documents.

Patent Document 1: PCT International Publication No. WO 99/49504
Patent Document 2: PCT International Publication No. WO2005/059617
Patent Document 3: PCT International Publication No. WO2005/059618

DISCLOSURE OF INVENTION

PROBLEMS TO BE SOLVED BY THE INVENTION

In a liquid immersion type exposure apparatus, the higher the refractive index of the liquid that fills an exposure light optical path space, the greater the resolution and/or the depth of focus. Even if a liquid is used that has a high refractive index as described above, it is still important to maintain the desired image forming characteristics and to satisfactorily expose the substrate.

MEANS FOR SOLVING THE PROBLEM

It is an object of the present invention to provide an exposure apparatus that can satisfactorily expose a substrate, as well as a device fabricating method that uses this exposure apparatus.

The present invention adopts the following configuration corresponding to the drawings illustrating the embodiments. However, parenthesized reference characters affixed to the respective elements are merely examples of those elements, and they do not limit the respective elements.

A first aspect of the present invention provides an exposure apparatus that exposes a substrate (P) through an immersion region (LR), comprising: an optical element (LS1) that has a concave surface (2) from which exposure light emerges; and a surface (20), which is provided so that it surrounds the optical path of the exposure light (EL), wherein an interface (LF) of the liquid (LQ) of the immersion region (LR) is held between the surface (20) and an object that is disposed at a position where it can be irradiated by the exposure light (EL).

According to the first aspect of the present invention, it is possible to suppress the outflow of the liquid that fills an optical path space, and to cause the exposure light to satisfactorily reach the substrate.

A second aspect of the present invention provides an exposure method, comprising the processes of: a process that forms an immersion region (LR) so that a space between an object and a concave surface (2) of an optical element (LS1) is filled with a liquid (LQ), and that positions an interface (LG) of the liquid (LQ) between the object and a surface (20), which is provided so that it faces the object and surrounds the optical path of exposure light (EL); and a process that exposes a substrate (P) through the immersion region (LR).

According to the second aspect of the present invention, it is possible to suppress the outflow of the liquid that fills the optical path space, and to cause the exposure light to satisfactorily reach the substrate.

A third aspect of the present invention provides a device fabricating method, wherein an exposure method according to the abovementioned aspects is used.

According to a third aspect of the present invention, it is possible to fabricate a device using the exposure method, wherein the exposure light can be made to satisfactorily reach the substrate.

A fourth aspect of the present invention provides an exposure apparatus that exposes a substrate (P) by radiating exposure light (EL) onto the substrate (P), comprising: a projection optical system (PL) that projects a pattern image onto the substrate (P) and that comprises a first optical element (LS1), which has a first surface (1) that the exposure light (EL) impinges and a second surface (2) from which the exposure light (EL) emerges; wherein, the first surface (1) and the second surface (2) are substantially concentric and are spherical surfaces; and the first optical element (LS1) is the element of the plurality of optical elements of the projection optical system (PL) that is closest to the image plane of the projection optical system (PL).

According to a fourth aspect of the present invention, it is possible to maintain the optical characteristics of the optical element and to satisfactorily expose the substrate.

A fifth aspect of the present invention provides an exposure apparatus (EX) that exposes a substrate (P) by radiating exposure light (EL) onto the substrate (P), comprising: an optical element (LS1) that has a concave surface part from which the exposure light (EL) emerges; a lower surface (63) that is provided so that it surrounds the concave surface part; and a side surface (84) that is provided on the outer side of the lower surface (63) with respect to the optical axis of the optical element (LS1) and that faces the optical axis.

According to a fifth aspect of the present invention, it is possible to maintain the optical characteristics of the optical element and to satisfactorily expose the substrate.

A sixth aspect of the present invention provides an exposure method that exposes a substrate (P) by radiating exposure light (EL) onto the substrate (P), comprising the steps of: radiating the exposure light (EL) to an optical element (LS1) that opposes a front surface of the substrate (P) and that has a concave surface part from which the exposure light (EL) emerges; irradiating the substrate (P) with the exposure light (EL) in a state wherein liquid (LQ) is filled between the concave surface part of the optical element (LS1) and a front surface of the substrate (P); and bringing the liquid (LQ) into contact with a lower surface (63), which is provided so that it surrounds the concave surface part, and a side surface (84), which is provided on the outer side of the lower surface (63) with respect to the optical axis of the optical element (LS1) and that faces the optical axis.

A seventh aspect of the present invention provides a device fabricating method wherein an exposure method according to the abovementioned aspects is used

EFFECTS OF THE INVENTION

According to the present invention, it is possible to suppress the outflow of the liquid that fills the optical path space of the exposure light, and to cause the exposure light to satisfactorily reach the substrate, and to satisfactorily expose the substrate.

According to the present invention, since the optical characteristics of the optical element is maintained, it is possible to satisfactorily expose the substrate with the desired image forming characteristics, and to manufacture a device having the desired performance.

BRIEF DESCRIPTION OF THE DRAWINGS

FIG. 1 is a schematic block diagram that shows an exposure apparatus according to a first embodiment.
FIG. 2 shows the principal parts of the exposure apparatus according to the first embodiment.
FIG. 3 is an explanatory diagram for explaining the exposure apparatus according to the first embodiment.
FIG. 4 shows the principal parts of the exposure apparatus according to a second embodiment.
FIG. 5 shows the principal parts of the exposure apparatus according to a third embodiment.
FIG. 6 shows the principal parts of the exposure apparatus according to a fourth embodiment.
FIG. 7 is a schematic block diagram that shows the exposure apparatus according to a fifth embodiment.
FIG. 8 shows the vicinity of the projection optical system according to the fifth embodiment.
FIG. 9a is a cross sectional view that shows a first optical element.
FIG. 9b is a plan view that shows the first optical element.
FIG. 10 is a side sectional view that shows the first optical element, which is supported by a support apparatus.
FIG. 11 is a plan view that shows the first optical element, which is supported by the support apparatus.
FIG. 12 shows the results of a simulation conducted to derive the pressure of the liquid.
FIG. 13 shows the results of a simulation that was conducted in order to derive the pressure of the liquid according to the fifth embodiment.
FIG. 14 shows the vicinity of the projection optical system according to a sixth embodiment.
FIG. 15 is a flow chart diagram for the purpose of explaining one example of the process of fabricating a microdevice.

DESCRIPTION OF THE REFERENCE SYMBOLS

2: CONCAVE SURFACE, 2F: FLANGE SURFACE, 4: SUBSTRATE STAGE, 5: LENS BARREL, 6: SUPPORT APPARATUS, 9: ADJUSTMENT APPARATUS, 10: FRONT SURFACE, 11: INCIDENT SURFACE, 12: LIGHT EMERGENT SURFACE, 20: LOWER SURFACE, 61: FIRST MEMBER, 63: FIRST LOWER SURFACE, 70: NOZZLE MEMBER, 84 : SIDE SURFACE, 71 : LOWER SURFACE, 108: SECOND MEMBER, AX: OPTICAL AXIS, C : CENTER OF CURVATURE, EL: EXPOSURE LIGHT, EX: EXPOSURE APPARATUS, K: OPTICAL PATH SPACE, LG: INTERFACE, LQ: LIQUID, LR: IMMERSION REGION, LS1: FINAL OPTICAL ELEMENT,, LS 11: FIRST OPTICAL ELEMENT, LS 12: SECOND OPTICAL ELEMENT, P: SUBSTRATE, PK: LENS BARREL, PL: PROJECTION OPTICAL SYSTEM

BEST MODE FOR CARRYING OUT THE INVENTION

The following explains the embodiments of the present invention, referencing the drawings, but the present invention is not limited thereto. Furthermore, the following explanation defines an XYZ orthogonal coordinate system, and the positional relationships of the members are explained by referencing this system. Prescribed directions within the horizontal plane are the X axial directions, directions that are orthogonal to the X axial directions in the horizontal plane are the Y axial directions, and directions (i.e., the vertical directions) that are orthogonal to the X axial directions and the Y axial directions are the Z axial directions. In addition, the rotational (inclined) directions about the X, Y, and Z axes are the $\theta X$, $\theta Y$, and $\theta Z$ directions, respectively.

<FIRST EMBODIMENT>

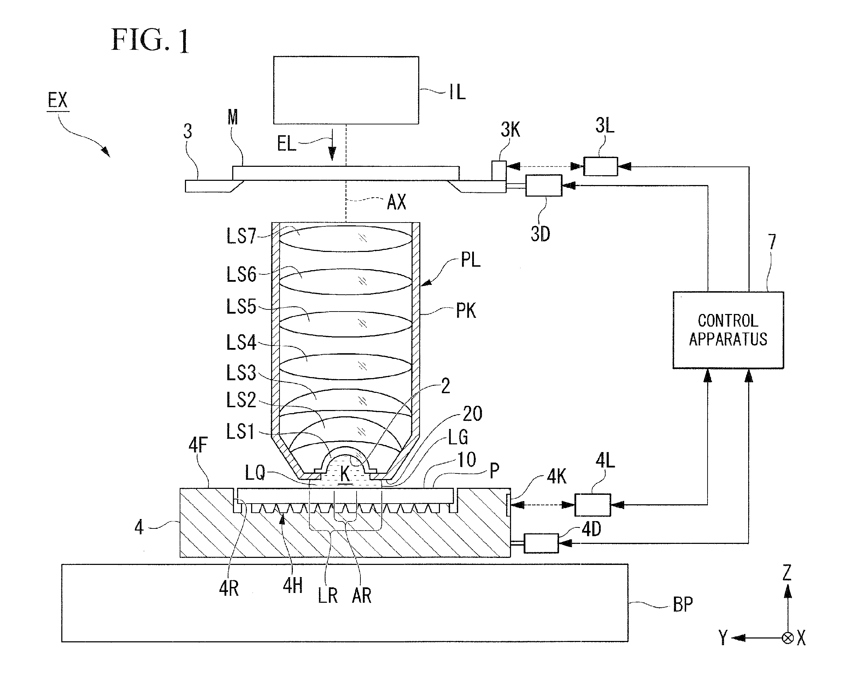

The first embodiment will now be explained. FIG. 1 is a schematic block diagram that shows an exposure apparatus EX according to a first embodiment. In FIG. 1, the exposure apparatus EX comprises a mask stage 3, which is capable of holding and moving a mask M; a substrate stage 4, which is capable of holding and moving a substrate P; an illumination optical system IL, which illuminates the mask M supported by the mask stage 3 with exposure light EL; a projection optical system PL, which projects a pattern image of the mask M illuminated by the exposure light EL onto the substrate P; and a control apparatus 7, which controls the entire operation of the exposure apparatus EX.

Furthermore, the substrate P described herein includes one wherein a film, such as a photosensitive material (photoresist) or a protective film, is coated on a base material, such as a semiconductor wafer. The mask M includes a reticle, wherein a device pattern is formed that is reduction projected onto the substrate P. In addition, a transmitting type mask is used as the mask M in the present embodiment, but a reflection type mask may also be used.

The exposure apparatus EX of the present embodiment is a liquid immersion type exposure apparatus that applies the liquid immersion method to substantially shorten the exposure wavelength, improve the resolution, as well as substantially increase the depth of focus. The exposure apparatus EX exposes the substrate P by radiating the exposure light EL through the projection optical system PL and the liquid LQ onto the substrate P. The projection optical system PL comprises a plurality of optical elements LS1-LS7, which are held by a lens barrel PK. The liquid LQ is filled between the substrate P and the final optical element LS1, which is the closest element of the plurality of optical elements LS1-LS7 to the image plane of the projection optical system PL. In addition, in the present embodiment, an optical axis AX of the projection optical system PL is parallel to the Z axial directions.

At least while the exposure apparatus EX is using the projection optical system PL to project the pattern image of the mask M onto the substrate P, the exposure apparatus EX fills the liquid LQ in a space K, which is along the optical path of the exposure light EL (hereinbelow, the exposure light optical path space K) and between the final optical element LS1 of the projection optical system PL and the substrate P. The exposure apparatus EX projects the pattern image of the mask M onto the substrate P to expose such by radiating the exposure light EL, which passes through the mask M, through the projection optical system PL and the liquid LQ, which fills the exposure light optical path space K, onto the substrate P, which is held by the substrate stage 4. In addition, the exposure apparatus EX of the present embodiment employs a local liquid immersion system, wherein the liquid LQ, which fills the exposure light optical path space K between the final optical element LS 1 and the substrate P, locally forms an immersion region LR, which is larger than a projection area AR of the projection optical system PL and smaller than the substrate P, in part of the area on the substrate P that includes the projection area AR.

The final optical element LS1, which is the closest element of the plurality of optical elements LS1-LS7 to the image plane of the projection optical system PL, comprises a concave surface 2 from which the exposure light EL emerges. A front surface 10 of the substrate P, which is held by the substrate stage 4, can be opposed to the concave surface 2 of the final optical element LS1, which is held by the lens barrel PK. The front surface 10 of the substrate P is the exposure surface whereon the photosensitive material is coated. In addition, the lens barrel PK, which holds the final optical element LS1, comprises a lower surface 20 that is provided so that it opposes the front surface 10 of the substrate P, which is disposed at a position where it can be irradiated by the exposure light EL (i.e., at a position opposing the concave surface 2), and so that it surrounds the exposure light optical path space K.

The liquid LQ fills the exposure light optical path space K between the concave surface 2 of the final optical element LS1 and the front surface 10 of the substrate P, which is held by the substrate stage 4. The concave surface 2 and the front surface 10 of the substrate P contact the liquid LQ that fills the optical path space K. When the immersion region LR is formed by filling the liquid LQ in the exposure light optical path space K between the concave surface 2 and the front surface 10 of the substrate P, an interface LG of the liquid LQ, which forms the immersion region LR, is formed so that it is maintained between the front surface 10 of the substrate P and the lower surface 20 of the lens barrel PK by the surface tension of the liquid LQ. The exposure apparatus EX radiates the exposure light EL onto the substrate P through the projection optical system PL, which includes the final optical element LS1, and the liquid LQ, which fills the space K between the concave surface 2 of the final optical element LS1 and the front surface 10 of the substrate P.

The illumination optical system IL illuminates a prescribed illumination region on the mask M with the exposure light EL, which has a uniform luminous flux intensity distribution. Examples of light that can be used as the exposure light EL emitted from the illumination optical system IL include: deep ultraviolet light (DUV light) such as bright line (g-line, h-line, or i-line) light emitted from, for example, a mercury lamp, and KrF excimer laser light (248 nm wavelength); and vacuum ultraviolet light (VUV light), such as ArF excimer laser light (193 nm wavelength) and $F_2$ laser light (157 nm wavelength). ArF excimer laser light is used as the exposure light EL in the present embodiment.

The mask stage 3, in a state wherein it holds the mask M, is movable in the X axial, Y axial and θZ directions by the drive of a mask stage drive apparatus 3D that comprises an actuator, such as a linear motor. A laser interferometer 3L measures the positional information of the mask stage 3 (as well as the mask M). The laser interferometer 3L uses a movable mirror 3K, which is provided on the mask stage 3, to measure the positional information of the mask stage 3. Based on the measurement result of the laser interferometer 3L, the control apparatus 7 controls the position of the mask M, which is held by the mask stage 3, by driving the mask stage drive apparatus 3D.

Furthermore, the movable mirror 3K may be one that includes a corner cube (retroreflector) and not simply a plane mirror; furthermore, it is acceptable to use, for example, a reflecting surface, which is formed by mirror polishing an end surface (side surface) of the mask stage 3, instead of providing the movable mirror 3K so that it is fixed to the mask stage 3. In addition, the mask stage 3 may be constituted so that it is coarsely and finely movable, as disclosed in, for example, Japanese Unexamined Patent Application, Publication No. H8-130179 (corresponding U.S. Patent No. 6,721,034).

The substrate stage 4 comprises a substrate holder 4H, which holds the substrate P, and, in a state wherein the substrate P is held by the substrate holder 4H, is movable on a base member BP in six degrees of freedom, i.e., the X axial, Y axial, Z axial, θX, θY, and θZ directions, by the drive of a substrate stage drive apparatus 4D that includes an actuator, such as a linear motor. The substrate holder 4H is disposed in a recessed part 4R, which is provided on the substrate stage 4. An upper surface 4F of the substrate stage 4 that is outside of the recessed part 4R is a flat surface that is substantially the same height as (flush with) the front surface of the substrate P, which is held by the substrate holder 4H. Furthermore, there may be a level difference between the front surface 10 of the substrate P, which is held by the substrate holder 4H, and the upper surface 4F of the substrate stage 4. In addition, part of the upper surface 4F of the substrate stage 4, e.g., just the prescribed area that surrounds the substrate P, may be at substantially the same height as the front surface 10 of the substrate P. Furthermore, the substrate holder 4H may be formed integrally with part of the substrate stage 4; however, in the present embodiment, the substrate holder 4H and the substrate stage 4 are constituted separately, and the substrate holder 4H is fixed to the recessed part 4R by, for example, vacuum chucking.

A laser interferometer 4L measures the positional information of the substrate stage 4 (as well as the substrate P). The laser interferometer 4L uses a movable mirror 4K, which is provided to the substrate stage 4, to measure the positional information of the substrate stage 4 in the X axial, Y axial and θZ directions. In addition, a focus and level detection system (not shown) detects the surface position information (positional information in the Z axial, θX and θY directions) of the front surface 10 of the substrate P, which is held by the substrate stage 4. Based on the measurement result of the laser interferometer 4L and the detection results of the focus and level detection system, the control apparatus 7 controls the position of the substrate P, which is held by the substrate stage 4, by driving the substrate stage drive apparatus 4D.

Furthermore, the laser interferometer 4L may also be capable of measuring the position of the substrate stage 4 in the Z axial directions and its rotational information in the θX, θY directions, the details of which are disclosed in, for example, Published Japanese Translation No. 2001-510577 of the PCT International Publication (corresponding PCT International Publication WO1999/28790). Furthermore, it is also acceptable to use a reflecting surface, which is formed by mirror polishing part (e.g., the side surface) of the substrate stage 4, instead of providing the movable mirror 4K so that it is fixed to the substrate stage 4.

In addition, the focus and level detection system may be one that detects the inclination information (rotational angle) of the substrate P in the θX and θY directions by measuring the positional information of the substrate P in the Z axial directions at a plurality of measurement points, and at least part of that plurality of measurement points may be set within the immersion region LR (or the projection area AR) or they may all be set outside of the immersion region LR. Furthermore, if, for example, the laser interferometer 4L is capable of measuring the positional information of the substrate P in the Z axial, θX and θY directions, then the focus and level detection system need not be provided so that the positional information of the substrate P can be measured in its Z axial directions during the exposure operation, and the position of the substrate P in the Z axial, θX and θY directions may be controlled using the measurement result of the laser interferometer 4L at least during the exposure operation.

Furthermore, the projection optical system PL of the present embodiment is a reduction system, wherein its projection magnification is, for example, 1/4, 1/5, or 1/8, and forms a reduced image of the pattern of the mask M in the projection area AR, which is optically conjugate with the illumination area discussed above. Furthermore, the projection optical system PL may be a reduction system, a unity magnification system, or an enlargement system. In addition, the projection optical system PL may be a refracting system, which does not include reflecting optical elements, a reflecting system, which does not include refracting optical elements, or a catadioptric system, which includes both refracting optical elements and reflecting optical elements. In addition, the projection optical system PL may form either an inverted image or an erect image.

The following explains the liquid LQ and the final optical element LS1. To simplify the explanation below, the refractive index of the liquid LQ with respect to the exposure light EL is properly called the refractive index of the liquid LQ, and the refractive index of the final optical element LS1 with respect to the exposure light EL is properly called the refractive index of the final optical element LS1.

In the present embodiment, the refractive index of the liquid LQ with respect to the exposure light EL (ArF excimer laser light: 193 nm wavelength) is higher than that of the final optical element LS1 with respect to the exposure light EL. The optical path space K is filled with the liquid LQ, which has a refractive index that is higher than that of the final optical element LS1. If, for example, the final optical element LS 1 is made of quartz, which has a refractive index of approximately 1.5, then the liquid used as the liquid LQ is one that has a refractive index that is higher, e.g., approximately 1.6-1.8, than that of quartz.

An optical path space of the final optical element LS1 on the +Z side (the side of the object plane and the mask) is filled with a gas (e.g., nitrogen). An optical path space of the final optical element LS1 on the -Z side (the side of the image plane and the substrate) is filled with the liquid LQ. A surface (hereinbelow, called the first surface) of the final optical element LS1 on the +Z side (the object plane side) comprises a convex curved surface (convex surface) that is curved toward the object plane side (mask side) of the projection optical system PL. That curved surface is shaped so that it is impinged by all of the light rays that form the image on the front surface (image plane) of the substrate P.

A surface (hereinbelow, called the second surface) of the final optical element LS1 on the -Z side (the image plane side) has a recessed curved surface (concave surface 2) that is curved in a direction away from the substrate P. The same as with the first surface, this second surface (concave surface 2) is shaped so that it is impinged by all of the light rays that form an image on the front surface of the substrate P.

Furthermore, the curved shapes of the first surface and the second surface of the final optical element LS1 can be appropriately determined so that the projection optical system PL achieves the desired performance. The first surface and the second surface may each be spherically shaped and have the same center of curvature, or they may be aspherically shaped. The numerical aperture NA of the projection optical system PL on the image plane side is expressed by the following equation:

$$NA = n \cdot \sin\theta \qquad (1)$$

Therein, n is the refractive index of the liquid LQ, and θ is the convergence half-angle. In addition, the resolution Ra and the depth of focus δ are expressed by the following equations:

$$Ra = k_1 \cdot \lambda/NA \qquad (2)$$

$$\delta = \pm k_2 \cdot \lambda/NA^2 \qquad (3)$$

Therein, λ is the exposure wavelength and $k_1$, $k_2$ are the process coefficients. Thus, the liquid LQ, which has a high refractive index (n), increases the numerical aperture NA by approximately n times, and it is therefore possible to significantly improve resolution and the depth of focus based on equations (2) and (3).

In addition, if an attempt is made to obtain a numerical aperture NA of the projection optical system PL that is greater than the refractive index of the final optical element LS1, and if the second surface that opposes the substrate P of the final optical element LS1 is a flat surface that is substantially perpendicular to the optical axis AX, then part of the exposure light EL is completely reflected by an interface (i.e., the second surface) between the final optical element LS1 and the liquid LQ, and that part of the exposure light EL therefore cannot reach the image plane of the projection optical system PL. For example, if the refractive index of the final optical element LS1 is $n_3$, the refractive index of the liquid LQ is $n_4$, the angle of the outermost light rays of the exposure light EL that impinge the interface (second surface) between the final optical element LS 1 and the liquid LQ with respect to the optical axis AX is $\theta_3$, and the angle of the outermost light rays that emerge from that interface (and that impinge the liquid LQ) with respect to the optical axis AX is $\theta_4$, then the following equation holds in accordance with Snell's law:

$$n_3\sin\theta_3 = n_4\sin\theta_4 \qquad (4)$$

In addition, if we use a refractive index $n_4$ of the liquid LQ and an angle $\theta_4$ of the outermost light rays that impinge the liquid LQ with respect to the optical axis AX, then the numerical aperture NA of the projection optical system PL is expressed by the following equation:

$$NA = n_4\sin\theta_4 \qquad (5)$$

The following equation holds from (4) and (5).

$$\sin\theta_3 = NA/n_3 \qquad (6)$$

Accordingly, as is obvious from equation (6), if the interface (second surface) between the final optical element LS1 and the liquid LQ is a flat surface that is substantially perpendicular to the optical axis AX, and the numerical aperture NA of the projection optical system PL is greater than a refractive index $n_3$ of the final

optical element LS1, then part of the exposure light EL cannot impinge the liquid LQ. In contrast, because the second surface of the final optical element LS 1 of the present embodiment comprises the concave surface 2, the outermost light rays of the exposure light EL can satisfactorily reach the image plane, even if the numerical aperture NA of the projection optical system PL is greater than the refractive index $n_3$ of the final optical element LS1.

Examples of the liquid LQ include prescribed liquids that have a C-H bond or an O-H bond, such as isopropanol and glycerol; prescribed liquids (organic solvents), such as hexane, heptane, and decane; and prescribed liquids, such as decalin and bicyclohexyl. Alternatively, two or more arbitrary types of these prescribed liquids may be mixed together, or a prescribed liquid mentioned above may be added to (mixed with) pure water. Alternatively, the liquid LQ may be one wherein a base, such as $H^+$, $Cs^+$, $K^+$. $Cl^-$, $SO_4^{2-}$, $PO_4^{2-}$, or an acid may be added to (mixed with) pure water. Furthermore, the liquid LQ may be a liquid wherein fine particles of aluminum oxide are added to (mixed with) pure water. These liquids LQ can transmit ArF excimer laser light. In addition, it is preferable that the liquid LQ is one that has a small light absorption coefficient, low temperature dependency, and is stable with respect to the photosensitive material coated on the projection optical system PL and/or the front surface of the substrate P.

In addition, the final optical element LS1 can be made of, for example, quartz (silica). Alternatively, it may be made of a monocrystalline fluorine compound material, such as calcium fluoride (fluorite), barium fluoride, strontium fluoride, lithium fluoride, sodium fluoride, and $BaLiF_3$. Furthermore, the final optical element LS1 may be made of lutetium aluminum garnet (LuAG). In addition, the optical elements LS2-LS7 can be made of the materials discussed above. In addition, the optical elements LS2-LS7 may be made of, for example, fluorite, and the optical element LS1 may be made of quartz; the optical elements LS2-LS7 may be made of quartz and the optical element LS1 may be made of fluorite; or, all of the optical elements LS1-LS5 may be made of quartz (or fluorite). In addition, a material that has a refractive index (e.g., $\geq$ 1.6) that is greater than quartz or fluorite may be used to make the optical elements of the projection optical system PL, including the final optical element LS1. For example, the optical elements of the projection optical system PL can be formed using sapphire or germanium dioxide, as disclosed in PCT International Publication WO2005/059617. Alternatively, the optical elements of the projection optical system PL can be formed using, for example, potassium chloride (refractive index of approximately 1.75), as disclosed in PCT International Publication WO2005/059618.

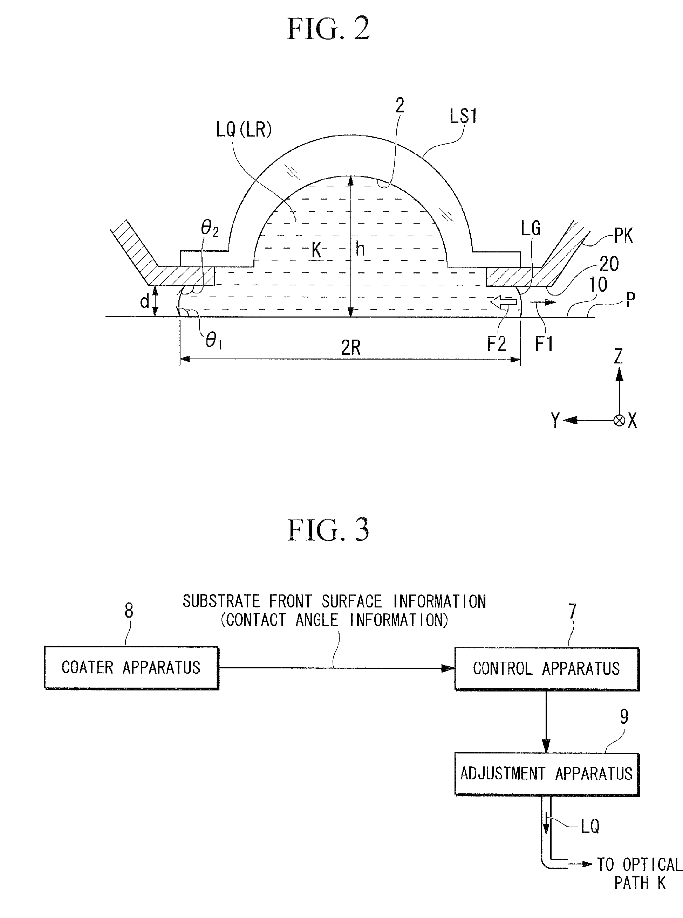

FIG. 2 shows the vicinity of the final optical element LS1. The lens barrel PK, which holds the final optical element LS1, comprises the lower surface 20, which is provided so that it opposes the front surface 10 of the substrate P on the substrate stage 4, which is disposed at a position where the front surface 10 can be irradiated by the exposure light EL (i.e., at a position opposing the concave surface 2), and so that it surrounds the exposure light optical path space K. In the present embodiment, the lower surface 20 surrounds the optical path space K and the concave surface 2, and is provided substantially parallel to the front surface 10 (in the XY plane) of the substrate P, which is held by the substrate stage 4. In addition, in the present embodiment, the lower surface 20 of the lens barrel PK is the surface of the projection optical system PL that is disposed closest to the front surface 10 of the substrate P, which is held by the substrate stage 4.

In the present embodiment, when the immersion region LR is formed by filling the liquid LQ in the exposure light optical path space K between the concave surface 2 of the final optical element LS 1 and the front surface 10 of the substrate P, which is held by the substrate stage 4, the interface LG of the liquid LQ, which forms the immersion region LR, is held and maintained between the front surface 10 of the substrate P and the lower surface 20 of the lens barrel PK by the surface tension of the liquid LQ. The interface LG refers to a boundary surface between the liquid LQ that fills the optical path space K and a gas space on the outer side thereof.

In the present embodiment, at least one of the liquid immersion conditions for forming the immersion region LR and the lens barrel PK lower surface 20 conditions is set so that the interface LG of the liquid LQ, which forms the immersion region LR, is held and maintained between the front surface 10 of the substrate P and the lower surface 20 of the lens barrel PK by the surface tension of the liquid LQ. At least one of the liquid immersion conditions and the lens barrel PK lower surface 20 conditions is set in accordance with the condition of the front surface 10 of the substrate P.

Here, the liquid immersion conditions include at least one of the density condition and the amount conditions of the liquid LQ, which forms the immersion region LR. The liquid LQ amount conditions include at least one of the distance condition between the front surface 10 of the substrate P and the position of the concave surface 2 that is closest to the front surface 10 of the substrate P, and the condition related to the size of the immersion region LR in the radial direction.

In addition, the lens barrel PK lower surface 20 conditions include at least one of the distance condition of the front surface 10 of the substrate P and the contact angle condition of the liquid LQ at the lower surface 20 of the lens barrel PK.

In addition, the substrate P front surface 10 conditions include the contact angle condition of the liquid LQ at the front surface 10 of the substrate P.

Specifically, at least one of the following is set: the liquid immersion conditions in accordance with the substrate P front surface 10 conditions so that the condition in equation (7), i.e., $\rho \times g \times h < (\gamma \times (\cos\theta_1 + \cos\theta_2)/d) + (\gamma/R) + P_A$, is satisfied; and the lens barrel PK lower surface 20 conditions.

Therein:

$\rho$: Density of the liquid LQ

g: Gravitational acceleration

h: Distance between the position of the concave surface 2 that is closest to the front surface 10 of the substrate P and that front surface 10

$\gamma$: Surface tension of the liquid LQ

$\theta_1$: Contact angle of the front surface 10 of the substrate P with respect to the liquid LQ

$\theta_2$: Contact angle of the lower surface 20 of the lens barrel PL with respect to the liquid LQ

d: Distance between the front surface 10 of the substrate P and the lower surface 20 of the lens barrel PL

R: Radius of the immersion region LR

$P_A$: Pressure of the surroundings of the immersion region LR

Therein, the immersion region LR is formed substantially circular in the X and Y directions. The radius R refers to the distance in the X or Y direction between the center (optical axis AX) and the edge of the immersion region LR.

The left term ($\rho \times g \times h$) of equation (7) describes the force (hereinbelow, called first force F1) of the liquid LQ that fills the exposure light optical path space K as it tries to spread to the outer side due to its own weight (static liquid pressure). The right term ($\gamma \times (\cos\theta_1 + \cos\theta_2)/d + \gamma/R$) of equation (7) describes the force (hereinbelow, called second force F2) that suppresses the spread of the liquid LQ, which fills the optical path space K, to the outer side due to the surface tension $\gamma$ of the liquid LQ at the interface LG.

Accordingly, setting at least one of the liquid immersion conditions for forming the immersion area LR and the conditions of the lower surface 20 of the lens barrel PK in accordance with the conditions of the front surface 10 of the substrate P so that the second force F2 is greater than the first force F1, i.e., so that the condition in equation (7) is satisfied, makes it possible to maintain the interface LG of the liquid LQ, which forms the immersion region LR, between the front surface 10 of the substrate P and the lower surface 20 of the lens barrel PK. Maintaining the interface LG of the liquid LQ, which forms the immersion region LR, between the front surface 10 of the substrate P and the lower surface 20 of the lens barrel PK makes it possible to suppress the outflow of liquid LQ that fills the optical path space K, to satisfactorily hold the liquid LQ on the inner side of the concave surface 2, and to bring the liquid LQ and the concave surface 2 into close contact. Accordingly, the occurrence of problems, such as the generation of a gas portion in the optical path space K (e.g., the interface between the concave surface 2 and the liquid LQ) is suppressed. Accordingly, the exposure light EL can be made to satisfactorily reach the substrate P.

To satisfy the condition of equation (7), the contact angles θ1, θ2 are preferably as large as possible. Namely, the front surface 10 of the substrate P and the lower surface 20 of the lens barrel PK are preferably liquid repellent with respect to the liquid LQ. In addition, the surface tension $\gamma$ of the liquid LQ is preferably as high as possible, and the density $\rho$ of the liquid LQ is preferably low. In addition, the distance d between the front surface 10 of the substrate P and the lower surface 20 of the lens barrel PK is preferably as small as possible. In addition, the radius R of the immersion region LR is preferably as small as possible, and the distance h between the front surface 10 of the substrate P and the position of the concave surface 2 closest thereto is preferably as small as possible. Namely, the amount of the liquid LQ that forms the immersion region LR is preferably as small as possible.

For example, the conditions of the lower surface 20 of the lens barrel PK can be set in accordance with the conditions of the front surface 10 of the substrate P. As discussed above, the conditions of the front surface 10 of the substrate P include the contact angle condition of the liquid LQ at the front surface 10 of the substrate P. For example, if a film of a prescribed material, such as a film made of a photosensitive material(hereinbelow, called a photosensitive material film), a liquid repellent film (hereinbelow, called a topcoat film) that is provided on a photosensitive material film in order to protect such from the liquid LQ, or an antireflection film, is formed on the front surface 10 of the substrate P, then there is a possibility that the contact angle θ1 of the liquid LQ at the front surface 10 of the substrate P will vary in accordance with the type (i.e., the material properties) of that film. Furthermore, it is possible to set the contact angle θ2 of the liquid LQ at the lower surface 20 of the lens barrel PK in accordance with the type of the film (i.e., one that has the contact angle θ1) formed on the front surface 10 of the substrate P so that the interface LG is maintained between the front surface 10 of the substrate P and the lower surface 20 of the lens barrel PK, e.g., so that the condition in equation (7) is satisfied. Treating the front surface of the lower surface 20 of the lens barrel PK and appropriately selecting the material used to make the lens barrel PK make it possible to obtain the contact angle θ2 of the liquid LQ at the lower surface 20 of the lens barrel PK so that the interface LG is maintained between the front surface 10 of the substrate P and the lower surface 20 of the lens barrel PK, e.g., so that the condition in equation (7) is satisfied.

In addition, the type of liquid LQ may be appropriately modified so that the interface LG is maintained between the front surface 10 of the substrate P and the lower surface 20 of the lens barrel PK (so that the condition in equation (7) is satisfied), or the material properties (density and surface tension) of the liquid LQ may be appropriately adjusted. Namely, appropriately modifying the type of the liquid LQ or appropriately adjusting the material properties makes it possible to fill the optical path space K with a liquid LQ that has a density ρ, surface tension γ, and contact angles θ1, θ2 so that the interface LG is maintained between the front surface 10 of the substrate P and the lower surface 20 of the lens barrel PK. For example, the condition in equation (7) can be satisfied by adjusting the material properties of the liquid LQ, e.g., by adding an additive to the liquid LQ or mixing multiple types of liquid so that a desired density ρ is obtained that satisfies the condition in equation (7).

In addition, in the example shown in FIG. 2, the radius R is determined in accordance with the amount of liquid LQ that is supplied to the optical path space K in order to fill such, and it is consequently possible to adjust the radius R by adjusting the amount of liquid LQ that is supplied. In addition, if the radius R is determined in accordance with the structure of a member that contacts the liquid LQ that fills the optical path space K (e.g., the structure of a nozzle member 70, which is discussed later), then the structure of that member should be optimized so that the interface LG is maintained between the front surface 10 of the substrate P and the lower surface 20 of the lens barrel PK (so that the condition in equation (7) is satisfied).

When designing the exposure apparatus EX, the distance d and the distance h should be determined so that the interface LG is maintained between the front surface 10 of the substrate P and the lower surface 20 of the lens barrel PK (so that equation (7) is satisfied).

In addition, pressure $P_A$ is the pressure in a gas space that surrounds the immersion region LR and that contacts the interface LG of the immersion region LR; in the present embodiment, the pressure $P_A$ is atmospheric pressure (1 atm). Furthermore, if a gas sealing mechanism is employed that suppresses the blowing of gas out of the immersion region LR at its circumference, and thereby suppresses the spreading of the immersion region LR, as disclosed in Japanese Unexamined Patent Application, Publication No. 2004-289126 (corresponding U.S. Patent Application Serial No. 2004/0207824), then the pressure $P_A$ of the surroundings of the immersion region LR should be determined by taking into consideration that gas blow out.

The following explains a method of using the exposure apparatus EX that has the constitution discussed above to expose the substrate P. In the present embodiment, the exposure apparatus EX is explained by taking as an example a case wherein the density ρ of the liquid immersion conditions of the liquid LQ, which forms the immersion region LR, is adjusted in accordance with the condition of the front surface 10 of the substrate P.

First, as shown in FIG. 3, a coater apparatus 8 treats the substrate P by coating the base material of the substrate P (e.g., a semiconductor wafer) with a prescribed material. A film of the prescribed material (photosensitive material film, topcoat film, antireflection film, or the like) is formed on the base material. Furthermore, the substrate P, which has the front surface 10 that is formed by that film of a prescribed material, is loaded on the substrate stage 4.

Information about the front surface 10 of the substrate P that is loaded on the substrate stage 4, i.e., information about the material film that is formed by the coater apparatus 8, is input in advance to the control apparatus 7. For example, a communication apparatus, which is capable of communicating a signal (information) between the coater apparatus 8 and the control apparatus 7, sends information about the material film formed by the coater apparatus 8 to the control apparatus 7.

The exposure apparatus EX comprises an adjustment apparatus 9 that adjusts the density ρ of the liquid LQ that is supplied between the concave surface 2 and the front surface 10 of the substrate P, and the control apparatus 7 uses the adjustment apparatus 9 to adjust the density ρ of the liquid LQ, which fills the optical path space K, in accordance with the condition of the front surface 10 of the substrate P.

The control apparatus 7 uses the adjustment apparatus 9 to adjust the density ρ of the liquid LQ, which fills the optical path space K, in order to satisfy the condition of equation (7). The adjustment apparatus 9 adjusts the density ρ of the liquid LQ that fills the optical path space K by, for example, adding an additive or mixing multiple types of liquid. Furthermore, the control apparatus 7 fills the liquid LQ, the density ρ of which has been adjusted, in the optical path space K between the concave surface 2 of the final optical element LS1 and the front surface 10 of the substrate P.

Furthermore, multiple types of liquid LQ that have mutually differing densities ρ may be prepared in advance, and the control apparatus 7 may select a liquid LQ from multiple types of liquid LQ in accordance with the conditions of the front surface 10 of the substrate P so that the condition of equation (7) is satisfied, and then fill the optical path space K with that liquid LQ.

By satisfying the condition in equation (7), the interface LG of the liquid LQ, which forms the immersion region LR, is formed between the front surface 10 of the substrate P and the lower surface 20 of the lens barrel PK by the surface tension of the liquid LQ, and the liquid LQ can therefore satisfactorily contact (closely contact) the concave surface 2 without any outflow of liquid LQ from the optical path space K.

The control apparatus 7 exposes the substrate P by irradiating it with the exposure light EL through the projection optical system PL, which includes the final optical element LS1, and the liquid LQ that fills the space K between the concave surface 2 of the final optical element LS1 and the front surface 10 of the substrate P.

The exposure apparatus EX of the present embodiment is a scanning type exposure apparatus (a so-called scanning stepper) that exposes the substrate P with the pattern formed on the mask M while synchronously moving the mask M and the substrate P in prescribed scanning directions (X or Y axial directions). In a state wherein the liquid LQ has filled the exposure light optical path space K, including the space on the inner side of the concave surface 2, the control apparatus 7 projects the pattern image of the mask M onto the substrate P through the projection optical system PL and the liquid LQ while synchronously moving the mask stage 3 and the substrate stage 4 in their respective scanning directions.

Even in a case where exposure is performed while moving the substrate P, the interface LG of the liquid LQ, which forms the immersion region LR, is maintained between the front surface 10 of the substrate P and the lower surface 20 of the lens barrel PK by the surface tension of the liquid LQ. Accordingly, the exposure apparatus EX can expose the substrate P in a state wherein the liquid LQ is caused to satisfactorily contact (closely contact) the concave surface 2 without causing any outflow of liquid LQ from the optical path space K.

As explained above, when the immersion region LR is formed by filling the liquid LQ in the exposure light optical path space K between the concave surface 2 of the final optical element LS1 and the front surface 10 of the substrate P, the concave surface 2 and the liquid LQ can be brought into close contact while suppressing the outflow of liquid LQ, which fills the optical path space K, by maintaining the interface LG of the liquid LQ, which forms the immersion region LR, between the front surface 10 of the substrate P and the lower surface 20 of the lens barrel PK by the surface tension of the liquid LQ. Accordingly, the exposure apparatus EX can suppress the occurrence of problems, such as the unfortunate generation of a gas portion in the optical path space K between the concave surface 2 and the front surface 10 of the substrate P, and can therefore expose the substrate P in a state wherein the liquid LQ satisfactorily fills the optical path space K.

Furthermore, in the present embodiment, the liquid immersion conditions (which includes the density of the liquid LQ) for forming the immersion region LR are adjusted in accordance with the substrate P front surface 10 conditions, but the lens barrel PK lower surface 20 conditions may also be adjusted.

<SECOND EMBODIMENT>

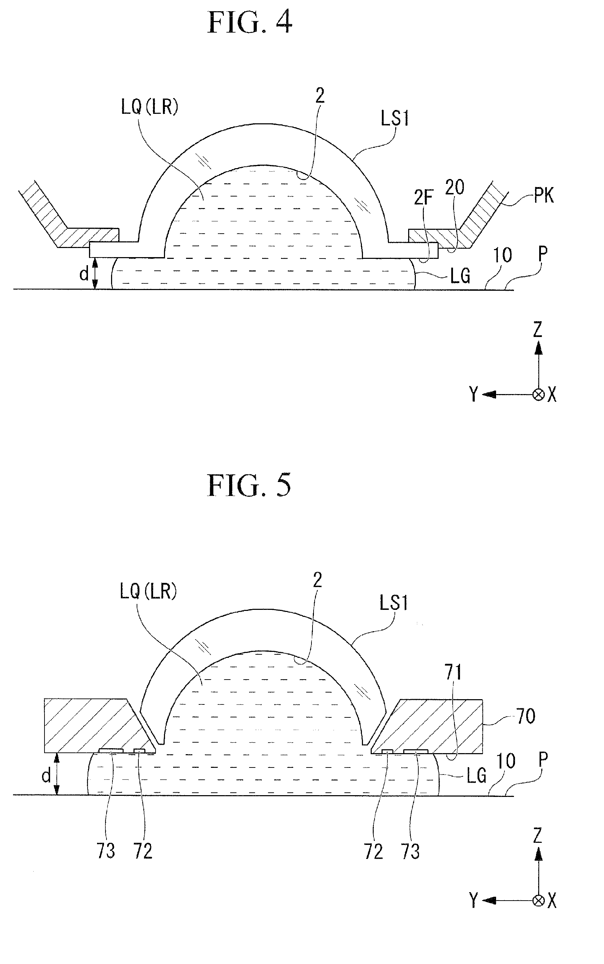

The following explains the second embodiment, referencing FIG. 4. In the second embodiment, constituent parts that are identical or equivalent to those in the embodiment discussed above are assigned the identical symbols, and the explanation of those parts is therefore simplified or omitted.

In the first embodiment discussed above, the interface LG of the liquid LQ, which fills the optical path space K, is formed between the front surface 10 of the substrate P, which is held by the substrate stage 4, and the lower surface 20 of the lens barrel PK, which holds the final optical element LS 1 that is the element of the projection optical system PL that is disposed closest to the front surface 10 of the substrate P; for example, as shown in FIG. 4, the interface LG may be formed between the front surface 10 of the substrate P, which is held by the substrate stage 4, and part of the final optical element LS 1. In FIG. 4, the final optical element LS1 comprises a flange surface 2F, which opposes the front surface 10 of the substrate P. The flange surface 2F is the surface of the projection optical system PL that is disposed closest to the front surface 10 of the substrate P. Maintaining the interface LG between the front surface 10 of the substrate P and the flange surface 2F of the final optical element LS1 suppresses the occurrence of problems, such as the outflow of liquid LQ and the generation of a gas portion in the optical path space K, and the exposure apparatus EX can therefore satisfactorily expose the substrate P.

<THIRD EMBODIMENT>

The following explains the third embodiment, referencing FIG. 5. In the third embodiment, constituent parts that are identical or equivalent to those in the embodiments discussed above are assigned the identical symbols, and the explanation of those parts is therefore simplified or omitted.

In FIG. 5, the exposure apparatus EX comprises a nozzle member 70, which is provided so that it surrounds the final optical element LS1, that has a supply port 72, which supplies liquid LQ to the optical path space K, and a recovery port 73, which recovers the liquid LQ. The nozzle member 70 has a lower surface 71, which is provided so that it opposes the front surface 10 of the substrate P held by the substrate stage 4, and so that it surrounds the exposure light optical path space K. The interface LG of the liquid LQ, which forms the immersion region LR, is maintained between the front surface 10 of the substrate P, which is held by the substrate stage 4, and the lower surface 71 of the nozzle member 70. Maintaining the interface LG between the front surface 10 of the substrate P and the lower surface 71 of the nozzle member 70 suppresses the occurrence of problems, such as the outflow of liquid LQ and the generation of a gas portion in the optical path space K, and the exposure apparatus EX can therefore satisfactorily expose the substrate P.

Furthermore, the nozzle member 70 may comprise either the supply port or the recovery port, and does not necessarily need to comprise both.

<FOURTH EMBODIMENT>

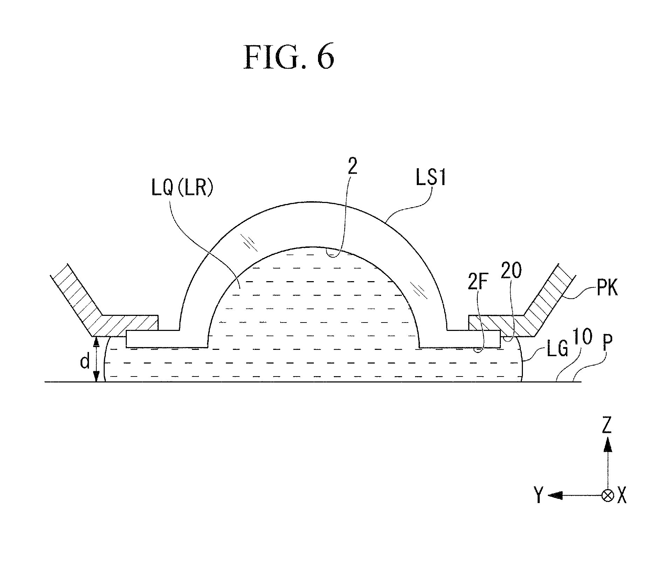

The following explains the fourth embodiment, referencing FIG. 6. In the fourth embodiment, constituent parts that are identical or equivalent to those in the embodiments discussed above are assigned the identical symbols, and the explanation of those parts is therefore simplified or omitted.

The first through third embodiments discussed above were explained by taking as an example a case wherein the interface LG of the liquid LQ, which forms the immersion region LR, is formed between the front surface 10 of the substrate P, which is disposed at a position where it can be irradiated by the exposure light EL, and the surface that is closest to the front surface 10 of the substrate P and is provided so that it opposes the front surface 10 of the substrate P and so that it surrounds the exposure light optical path space K; however, as shown in FIG. 6, the interface LG may be formed between the front surface 10 of the substrate P and the lower surface 20 of the lens barrel PK, which is further from the front surface 10 of the substrate P than the flange surface 2F (which is closest to the front surface 10 of the substrate P), and is provided so that it opposes the front surface 10 of the substrate P and surrounds the exposure light optical path space K. Maintaining the interface LG between the front surface 10 of the substrate P and the lower surface 20 of the lens barrel PK suppresses the occurrence of problems, such as the outflow of liquid LQ and the generation of a gas portion in the optical path space K, and the exposure apparatus EX can therefore satisfactorily expose the substrate P.

Furthermore, each of the embodiments discussed above was explained by taking as an example a case wherein the immersion region LR is substantially circular in the X and Y directions; however, if the immersion region LR in the X and Y directions is non-circular, then the size of the immersion region LR (the amount of the liquid LQ that fills the optical path space K) should be determined by, for example, experimentation or simulation so that the interface LG is maintained between the front surface 10 of the substrate P and the lower surface 20 of the lens barrel PK.

Furthermore, in each of the embodiments discussed above, the lower surface 20 of the lens barrel PK, the flange surface 2F of the final optical element LS1, the lower surface 71 of the nozzle member 70, and the like are substantially parallel to the front surface 10 of the substrate P (in the XY plane), which is held by the substrate stage 4, but these elements may be inclined with respect to the front surface 10 of the substrate P.

In addition, in each of the embodiments discussed above, at least one of the conditions (conditions of the exposure apparatus EX), such as the liquid immersion conditions for forming the immersion region LR and, for example, the lens barrel PK lower surface 20 conditions is set so that the interface LG is formed between the front surface 10 of the substrate P and the lower surface 20 of the lens barrel PK in accordance with the substrate P front surface 10 conditions (so that the condition in equation (7) is satisfied); however, the substrate P front surface 10 conditions may be set in accordance with the conditions of the exposure apparatus EX (the liquid immersion conditions, the lens barrel PK lower surface 20 conditions, and the like). Namely, when determining the conditions of the exposure apparatus EX, which include: the type of the liquid LQ used; the amount of the liquid LQ that fills the optical path space K (radius R and distance h); the distance d between the front surface 10 of the substrate P and the lower surface 20 of the lens barrel PK; and the contact angle condition of the liquid LQ at the lower surface 20 of the lens barrel PK and the like, the substrate P front surface 10 conditions is set in accordance with the conditions of the exposure apparatus EX so that the interface LG is formed between the front surface 10 of the substrate P and the lower surface 20 of the lens barrel PK (so that the condition in equation (7) is satisfied). For example, the control apparatus 7 inputs the conditions (information) of the exposure apparatus EX into the coater apparatus 8, which is for coating the front surface 10 of the substrate P with a material film. The coater apparatus 8 can form a material film on the substrate P in accordance with the conditions of the exposure apparatus EX so that the interface LG is formed between the front surface 10 of the substrate P and the lower surface 20 of the lens barrel PK (so that the condition in equation (7) is satisfied).

Of course, the exposure apparatus EX and the coater apparatus 8 may be separate apparatuses, and the material film may be selected in accordance with the conditions of the exposure apparatus EX.

Furthermore, each of the embodiments discussed above explained that the interface LG that forms the immersion region LR is maintained between the front surface 10 of the substrate P and, for example, the lower surface 20, which is provided so that it opposes the front surface 10 and so that it surrounds the exposure light optical path space K; however, the interface LG may be formed between a front surface of an object, which is not the substrate P and that is disposed at a position where it can be irradiated by the exposure light EL, and a surface that opposes that front surface. For example, the interface LG may be formed between the upper surface 4F of the substrate stage 4 and the lower surface 20 of the lens barrel PK.

In addition, each of the embodiments discussed above was explained by taking as an example a case wherein the liquid LQ was filled between the concave surface 2 of the final optical element LS1 and the substrate P, which opposes the concave surface 2; however, on the image plane side of the projection optical system PL, the exposure apparatus EX can fill the liquid LQ between the concave surface 2 of the final optical element LS 1 and a part, e.g., the substrate stage 4, that opposes that concave surface 2.

<FIFTH EMBODIMENT>

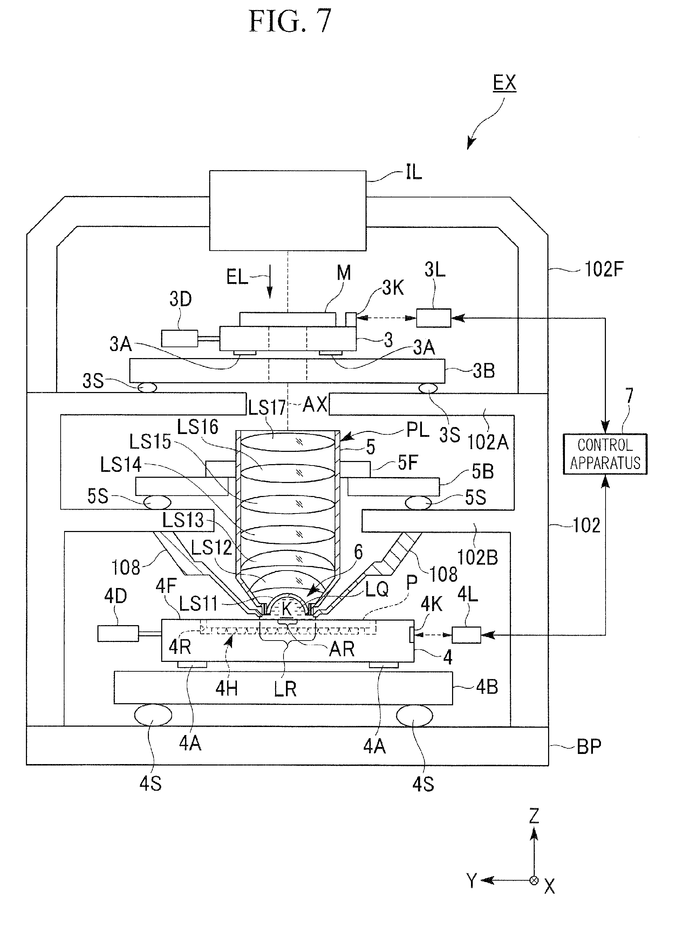

The following explains the fifth embodiment, referencing FIG. 7. FIG. 7 is a schematic block diagram that shows the exposure apparatus according to the fifth embodiment. Constituent parts that are identical or equivalent to those in the embodiments discussed above are assigned identical symbols, and the explanation of those parts is therefore simplified or omitted.

The present embodiment will now be explained by taking as an example a case of using a scanning type exposure apparatus (a so-called scanning stepper) as the exposure apparatus EX that exposes the substrate P with the pattern formed on the mask M, while synchronously moving the mask M and the substrate P in their respective scanning directions. In the following explanation, the directions in which the mask M and the substrate P synchronously move (scanning directions) within the horizontal plane are the Y axial directions, the directions orthogonal to the Y axial directions within the horizontal plane are the X axial directions (non-scanning directions), and the directions perpendicular to the X and Y axial directions and parallel to the optical axis AX of the projection optical system PL are the Z axial directions. In addition, the rotational (inclined) directions about the X, Y, and Z axes are the θX, θY, and θZ directions, respectively.

The same as in the abovementioned embodiments, the exposure apparatus EX of the present embodiment is a liquid immersion type exposure apparatus that applies the liquid immersion method to substantially shorten the exposure wavelength, improve the resolution, as well as substantially increase the depth of focus, and exposes the substrate P by radiating the exposure light EL through the projection optical system PL and the liquid LQ onto the substrate P. The liquid LQ is filled between the substrate P and a first optical element LS11, which is the closest element of the plurality of optical elements LS 11-LS 17 to the image plane of the projection optical system PL.

At least while the exposure apparatus EX is using the projection optical system PL to project the pattern image of the mask M onto the substrate P, the exposure apparatus EX fills the liquid LQ in a prescribed space, which includes the exposure light optical path space K, between the first optical element LS11 and the substrate P. The exposure apparatus EX projects the pattern image of the mask M onto the substrate P to expose such by radiating the exposure light EL, which passes through the mask M, through the projection optical system PL and the liquid LQ, which fills the exposure light optical path space K, onto the substrate P, which is held by the substrate stage 4. In addition, the exposure apparatus EX of the present embodiment employs a local liquid immersion system, wherein the liquid LQ, which fills the exposure light optical path space K between the first optical element LS 11 and the substrate P, locally forms the immersion region LR, which is larger than the projection area AR of the projection optical system PL and smaller than the substrate P, in part of the area on the substrate P that includes the projection area AR.

The exposure apparatus EX comprises the base BP, which is provided on a floor surface, and a main frame 102, which is installed on the base BP. The illumination system IL is supported by a sub-frame 102F, which is fixed to an upper part of the main frame 102. The mask stage 3 is noncontactually supported by an air bearing 3A with respect to an upper surface (guide surface) of a mask stage base plate 3B. The mask stage base plate 3B is supported by an upper side support member 102A, which projects toward the inner side of the main frame 102, via a vibration isolating apparatus 3S. The substrate stage 4 comprises the substrate holder 4H, which holds the substrate P, and, in a state wherein the substrate P is held by the substrate holder 4H, is movable on a substrate stage base plate 4B in six degrees of freedom, i.e., the X axis, Y axis, Z axis, θX, θY, and θZ directions, by the drive of the substrate stage drive apparatus 4D that includes an actuator, such as a linear motor. The substrate stage 4 is noncontactually supported by an air bearing 4A with respect to an upper surface (guide surface) of the substrate stage base plate 4B. The substrate stage base plate 4B is supported by the base BP via a vibration isolating apparatus 4S.

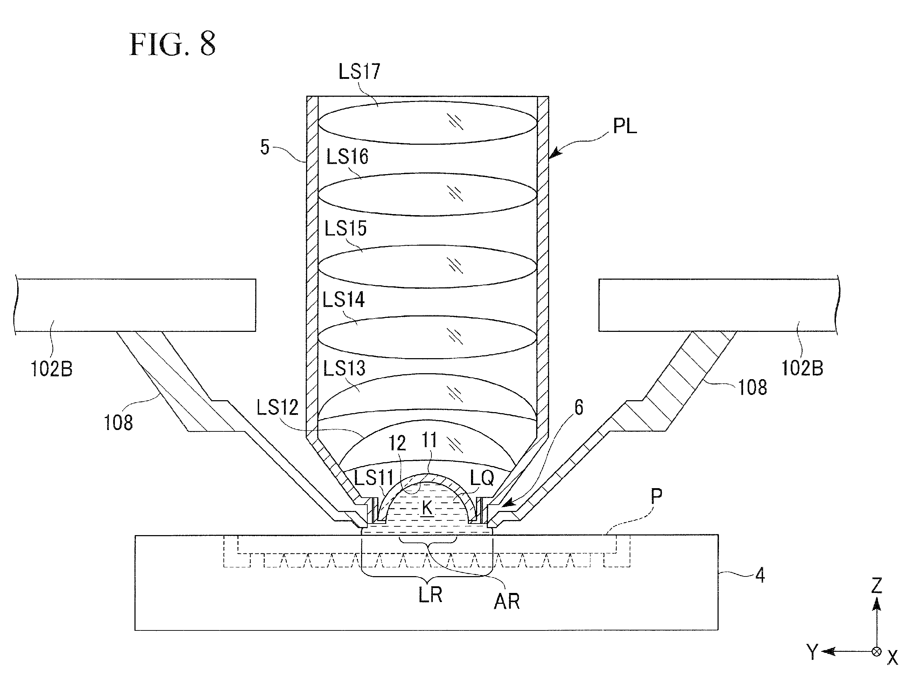

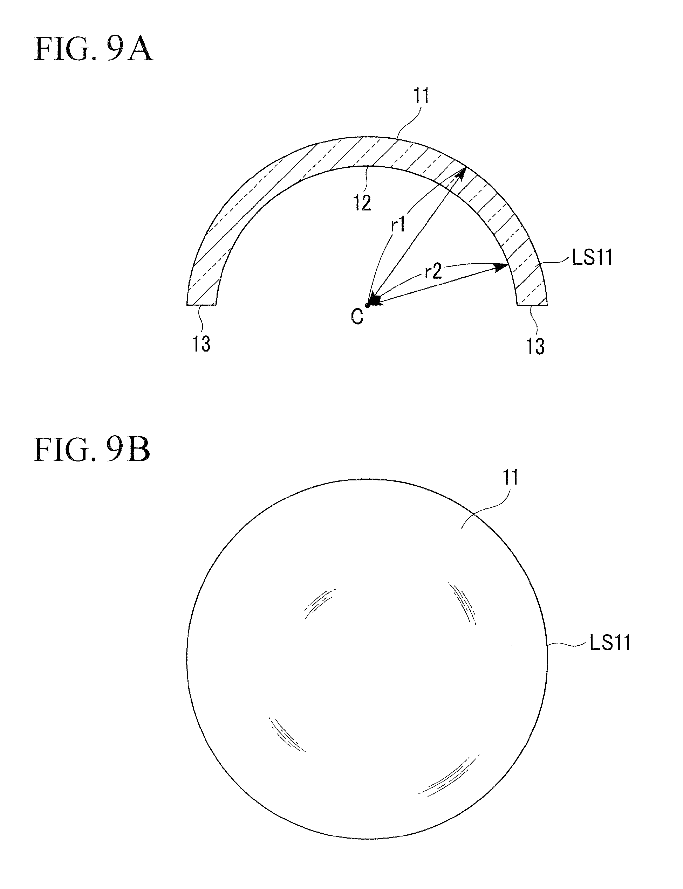

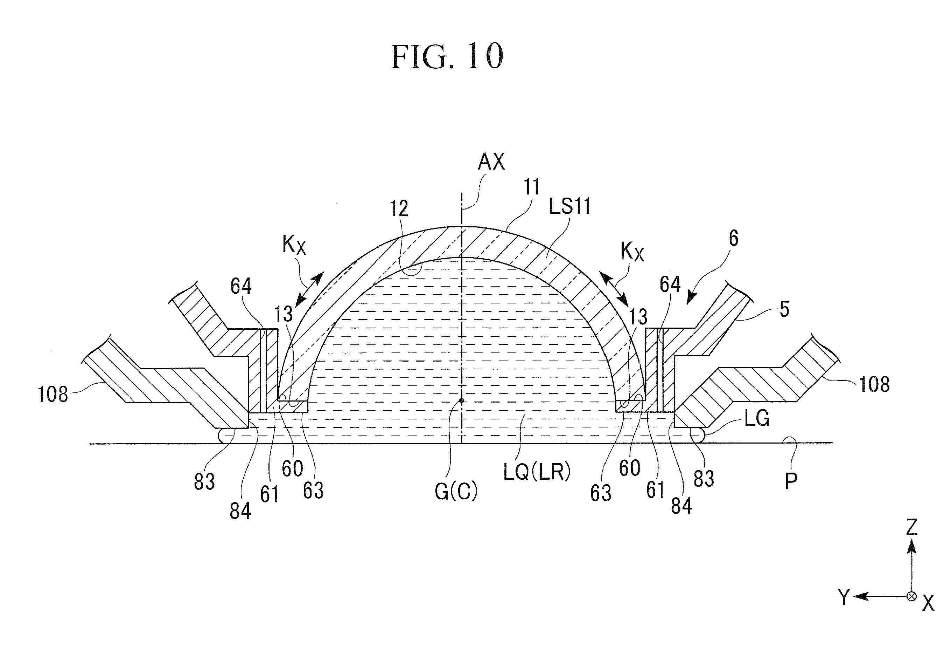

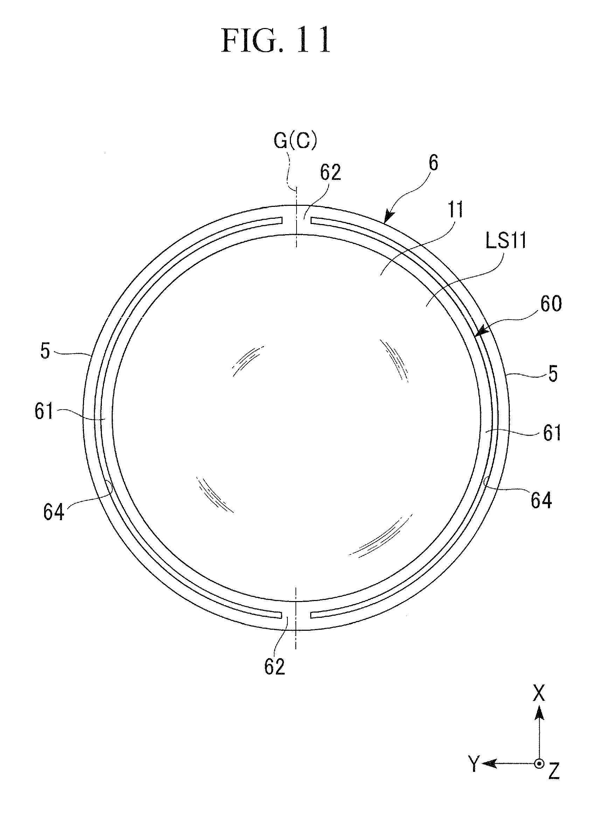

The following explains the projection optical system PL of the present embodiment, referencing FIG 7 through FIG. 11. FIG. 8 shows the vicinity of the projection optical system PL. FIG. 9a is a side sectional view that shows the first optical element LS11, and FIG. 9b is a plan view thereof. FIG. 10 is a side sectional view that shows the first optical element LS11 supported by a lens barrel 5, and FIG. 11 is a plan view that shows the first optical element LS11 supported by the lens barrel 5.

In FIG. 7, the projection optical system PL is a system that projects the pattern image of the mask M onto the substrate P with a prescribed projection magnification, and comprises the optical elements LS11-LS17. The optical elements LS11-LS17 are held by the lens barrel 5. In the present embodiment, the optical axis AX of the projection optical system PL, which includes the first optical element LS11, and the Z axial directions are parallel to one another. The lens barrel 5 comprises a flange 5F, and the projection optical system PL is supported by a lens barrel base plate (main column) 5B via the flange 5F. The main column 5B is supported via a lower side support member 102B, which projects toward the inner side of the main frame 102, via a vibration isolating apparatus 5S.

As shown in FIG. 8 through FIG. 11, the first optical element LS 11 comprises an incident surface 11, which the exposure light EL impinges, and a light emergent surface 12, from which the exposure light EL emerges. The incident surface 11 and the light emergent surface 12 of the first optical element LS11 are substantially concentric. The incident surface 11 has a convex spherical surface, and the light emergent surface 12 has a concave spherical surface. Namely, the first optical element LS11 comprises the convex surface 11 and the concave surface 12. As shown in FIG. 9a and FIG. 9b, the centers of curvature of the incident surface 11 and the light emergent surface 12 coincide. The distance (radius of curvature) between a center of curvature C and the incident surface 11 is rl, and the distance (radius of curvature) between the center of curvature C and the light emergent surface 12 is r2.

The exposure apparatus EX radiates the exposure light EL onto the substrate P in a state wherein the light emergent surface 12 of the first optical element LS11 and the front surface 10 of the substrate P are opposed and a prescribed space, which includes the exposure light optical path space K between the light emergent surface 12 of the first optical element LS11 and the front surface 10 of the substrate P, is filled with the liquid LQ. Here, the front surface 10 of the substrate P refers to the exposure surface, which is coated with a photosensitive material. The light emergent surface 12 and the substrate P contact the liquid LQ that fills the optical path space K.

As shown in FIG. 10 and FIG. 11, the first optical element LS11 in the present embodiment is supported by a support apparatus 6, which is provided to a lower end of the lens barrel 5. The support apparatus 6 rotatably supports the first optical element LS 11 with the center of curvature C of the incident surface 11 and the light emergent surface 12 as the center of rotation. In the present embodiment, the exposure apparatus EX exposes the substrate P while moving the first optical element LS11 and the substrate P relative to one another in the Y axial directions in a state wherein the liquid LQ is filled between the light emergent surface 12 of the first optical element LS11 and the front surface 10 of the substrate P. The support apparatus 6 rotatably supports the first optical element LS 11 (refer to arrow Kx in FIG. 10) about an axis G, which passes through the center of curvature C and is parallel to the X axial directions that intersect the Y axial directions, i.e., the θX directions with the axis G as the center of rotation.

The support apparatus 6 comprises a first member 61, which has a support surface 60 that supports a lower end surface 13 of the first optical element LS 11, and connecting members 62, which connect the lower end of the lens barrel 5 and the end surface on both sides of the first member 61 in the X axial directions . The connecting members 62 support the first member 61 so that it is capable of rotating (inclining) in the θX directions with respect to the lens barrel 5. A slit 64 is formed between the first member 61 and the lens barrel 5. The first member 61 is rotatable with respect to the lens barrel 5. The connecting members 62 rotatably support the first member 61, which has the support surface 60 that supports the first optical element LS11, so that the first optical element LS11 is rotatable about the axis G.

Furthermore, in the present embodiment, the first member 61 and the connecting member 62 are formed by the formation of the slit 64, which has a width (slit width) of, for example, less than 0.5 mm, in part of the lower end of the lens barrel 5 by, for example, electrical discharge machining.

The exposure apparatus EX comprises a first lower surface 63, which is provided on the outer side of the light emergent surface 12 with respect to the optical axis AX of the first optical element LS11 so that it opposes the front surface 10 of the substrate P. In the present embodiment, the first lower surface 63 includes a lower surface of the first member 61, which supports the first optical element LS 11, and a lower surface of the lens barrel 5. In the present embodiment, the first member 61 is annularly formed so that it corresponds to the contour of the first optical element LS11. Specifically, the first lower surface 63 is annularly formed so that it surrounds the light emergent surface 12. In addition, the first lower surface 63 is formed substantially perpendicular to the optical axis AX of the first optical element LS11. Namely, the first lower surface 63 is formed substantially parallel to the XY plane (the horizontal plane).

In addition, the exposure apparatus EX comprises a side surface 84 that faces the optical axis AX and is provided on the outer side of the first lower surface 63 with respect to the optical axis AX of the first optical element LS11 and at a position that is closer to the front surface 10 of the substrate P than that of the first lower surface 63. In the present embodiment, a second member 108, which is separate from the lens barrel 5 and the first member 61, is connected to the lower side support member 102B of the main frame 102, and the side surface 84 is formed in that second member 108. The second member 108 is disposed on the outer side of the lens barrel 5 with respect to the optical axis AX of the projection optical system PL, and is formed so that it surrounds the lens barrel 5. The side surface 84 is annularly formed on the outer side of the first lower surface 63 with respect to the optical axis AX of the first optical element LS11 so that it surrounds the optical axis AX. In addition, the side surface 84 is formed substantially parallel to the optical axis AX, i.e., the Z axial directions.

In the present embodiment, the first member 61 (lens barrel 5), which has the first lower surface 63, and the second member 108, which forms the side surface 84, are slightly spaced apart. Furthermore, the first member 61 (lens barrel 5), which has the first lower surface 63, and the second member 108, which forms the side surface 84, may contact one another.

The side surface 84 is provided in order to reduce the force of the liquid LQ that acts upon the light emergent surface 12 of the first optical element LS11, and so that the pressure of the liquid LQ that acts upon the light emergent surface 12 falls below the pressure of the liquid LQ that acts upon the first lower surface 63. Specifically, the side surface 84 is disposed so that the pressure of the liquid LQ that acts upon the light emergent surface 12 decreases in the X and Y directions of the first optical element LS11, and so that the pressure of the liquid LQ that acts upon the light emergent surface 12 in the X and Y directions of the first optical element LS 11 falls below the pressure of the liquid LQ that acts upon the first lower surface 63 in the Z axial directions.

In addition, the second member 108 comprises a second lower surface 83, which is provided so that it opposes the front surface 10 of the substrate P and is provided on the outer side of the first lower surface 63 and the side surface 84 with respect to the optical axis AX of the first optical element LS 11. The second member 108 is formed so that it surrounds the first member 61 and the lens barrel 5, and the second lower surface 83 is annularly formed so that it surrounds the light emergent surface 12, the side surface 84, and the first lower surface 63. In addition, the second lower surface 83 is formed substantially parallel to the XY plane (the horizontal plane).

As shown in FIG. 10 and the like, the liquid LQ, which forms the immersion region LR on the substrate P, is held between the light emergent surface 12 and the front surface 10 of the substrate P, and between at least part of the first lower surface 63 and the front surface 10 of the substrate P. In the present embodiment, when forming the immersion region LR by filling the liquid LQ in the exposure light optical path space K between the light emergent surface 12 and the front surface 10 of the substrate P, the interface LG of the liquid LQ, which forms the immersion region LR, is maintained between the front surface 10 of the substrate P and the second lower surface 83 by the surface tension of the liquid LQ. The interface LG refers to the boundary surface between the liquid LQ that fills the optical path space K and the gas space on the outer side thereof. The exposure apparatus EX radiates the exposure light EL onto the substrate P through the projection optical system PL, which includes the first optical element LS 11, and the liquid LQ that is filled between the light emergent surface 12 of the first optical element LS 11 and the front surface 10 of the substrate P.

In the present embodiment, at least one of the liquid immersion conditions, which are for forming the immersion region LR, and the second lower surface 83 conditions is set so that the interface LG of the liquid LQ, which forms the immersion region LR, is maintained between the front surface 10 of the substrate P and the second lower surface 83 by the surface tension of the liquid LQ. At least one of the liquid immersion conditions and the second lower surface 83 conditions is set in accordance with the substrate P front surface 10 conditions. Here, the liquid immersion conditions include the conditions related to at least one of the density and the amount of the liquid LQ that forms the immersion region LR. The conditions related to the liquid LQ amount include at least one of the distance condition between the front surface 10 of the substrate P and the position of the light emergent surface 12 that is farthest from the front surface 10 of the substrate P, and the condition related to the size of the immersion region LR in the radial direction. In addition, the second lower surface 83 conditions include at least one of the distance condition to the front surface 10 of the substrate P, and the contact angle condition of the liquid LQ at the second lower surface 83. In addition, the substrate P front surface 10 conditions include the contact angle condition of the liquid LQ at the front surface 10 of the substrate P. By optimizing each of these conditions, it is possible to maintain the interface LG between the front surface 10 of the substrate P and the second lower surface 83, as well as to suppress the outflow of liquid LQ, even if the first optical element LS11 and the substrate P move relative to one another in a state wherein the liquid LQ is filled between the light emergent surface 12 of the first optical element LS 11 and the front surface 10 of the substrate P.

The following explains the liquid LQ and the first optical element LS11. To simplify the explanation below, the refractive index of the liquid LQ with respect to the exposure light EL is properly called the refractive index of the liquid LQ, and the refractive index of the first optical element LS11 with respect to the exposure light EL is properly called the refractive index of the first optical element LS11.

In the present embodiment, the refractive index of the liquid LQ with respect to the exposure light EL (ArF excimer laser light: 193 nm wavelength) is higher than that of the first optical element LS11 with respect to the exposure light EL. The optical path space K is filled with the liquid LQ, which has a refractive index that is higher than that of the first optical element LS11. If, for example, the first optical element LS11 is made of quartz, which has a refractive index of approximately 1.5, then the liquid that can be used as the liquid LQ is one that has a refractive index that is higher, e.g., approximately 1.6-2.0, than that of quartz.

The optical path space on the +Z side (object plane and mask side) of the first optical element LS11 is filled with gas (e.g., nitrogen), and the optical path space on the -Z side (image plane and substrate side) of the first optical element LS11 is filled with the liquid LQ. As discussed above, the first optical element LS11 comprises a concavo-convex lens, which has the convex incident surface 11 and the concave light emergent surface 12. Namely, the incident surface 11 on the +Z side of the first optical element LS11 and the light emergent surface 12 on the -Z side of the first optical element LS11 each have a curved surface (spherical surface) that is curved in a direction away from the front surface 10 of the substrate P, and is shaped so that all the light rays that form the image on the front surface 10 (image plane) of the substrate P impinge those surfaces.

As is clear from equations (1)-(6) discussed above, if the interface (light emergent surface 12) between the first optical element LS11 and the liquid LQ were a flat surface substantially perpendicular to the optical axis AX, and the numerical aperture NA of the projection optical system PL were greater than the refractive index $n_1$ of the first optical element LS11, then part of the exposure light EL could not impinge the liquid LQ. In contrast, because the light emergent surface 12 of the first optical element LS11 in the present embodiment is a curved surface (spherical surface), the angles of incidence of the light rays that impinge the interface between the first optical element LS11 and the liquid LQ are small, even if the numerical aperture NA of the projection optical system PL is larger than the refractive index $n_1$ of the first optical element LS11, and the outermost light rays of the exposure light EL can satisfactorily reach the image plane.

Thus, even if the refractive index of the liquid LQ with respect to the exposure light EL is higher than the refractive index of the first optical element LS11 with respect to the exposure light EL, and even if the numerical aperture NA of the projection optical system PL is higher than the refractive index of the first optical element LS11 with respect to the exposure light EL, the exposure light EL can be made to satisfactorily reach the substrate P by making the light emergent surface 12 of the first optical element LS11 a curved surface (spherical surface, concave surface) that is curved in a direction away from the front surface 10 of the substrate P.

The following explains a method of exposing the substrate P by using the exposure apparatus EX that has the constitution discussed above.

The control apparatus 7 starts the exposure of the substrate P after the liquid LQ is filled in the space, which includes the optical path space K, between the light emergent surface 12 of the first optical element LS11 and the front surface 10 of the substrate P. As discussed above, the exposure apparatus EX of the present embodiment is a scanning type exposure apparatus (a so-called scanning stepper) that exposes the substrate P with the pattern formed on the mask M while synchronously moving the mask M and the substrate P in prescribed scanning directions (in the present embodiment, the Y axial directions). In a state wherein the liquid LQ is filled between the light emergent surface 12 of the first optical element LS11 and the front surface 10 of the substrate P, the control apparatus 7 projects the pattern image of the mask M onto the substrate P through the projection optical system PL and the liquid LQ while synchronously moving the mask stage 3 and the substrate stage 4 in their respective scanning directions.

If the substrate P moves with respect to the first optical element LS11 in a state wherein the liquid LQ is filled between the light emergent surface 12 of the first optical element LS11 and the front surface 10 of the substrate P, then the force (pressure) of the liquid LQ will act upon, for example, the light emergent surface 12, and there is consequently a possibility that the light emergent surface 12 will slightly deform or that the first optical element LS11 will move.

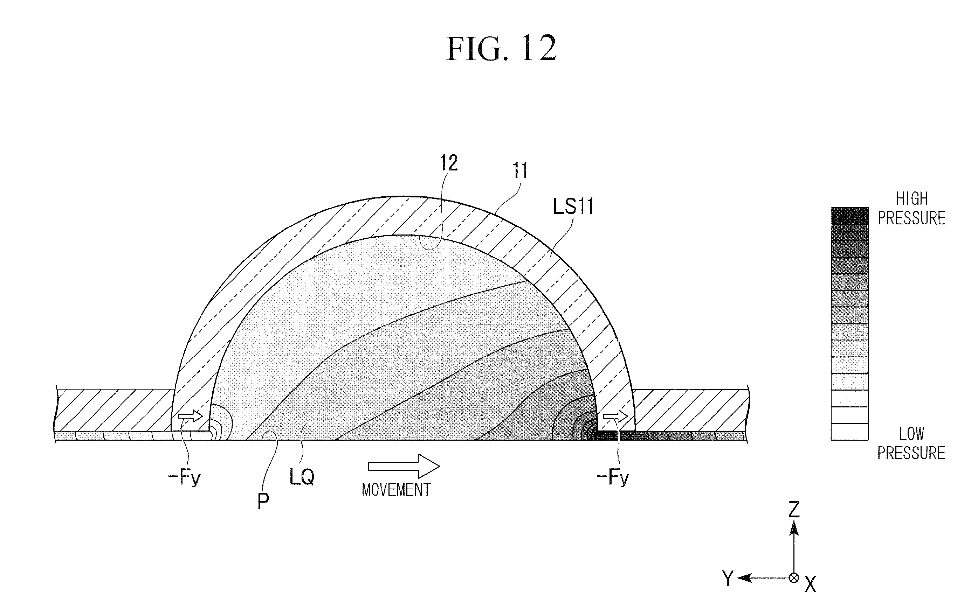

FIG. 12 shows the results of a simulation that models the pressure (pressure distribution) of the liquid LQ when the substrate P has moved with respect to the first optical element LS11 in a state wherein the liquid LQ is filled between the light emergent surface 12 of the first optical element LS11 and the front surface 10 of the substrate P. FIG. 12 shows the simulation results for a case wherein the side surface 84 is not provided. In addition, in this figure, areas where the pressure of the liquid LQ is high are indicated by darker colors, and areas where the pressure of the liquid LQ is low are indicated by lighter colors.

If the substrate P moves in the -Y direction with respect to the first optical element LS11, then, as shown in FIG. 12, the pressure of the liquid LQ that acts upon the light emergent surface 12 increases in the -Y direction. Namely, the movement of the substrate P in the -Y direction causes a strong liquid LQ force -Fy in the -Y direction to act upon the circumferential edge area of the light emergent surface 12. If a liquid LQ force -Fy is generated in the movement direction of the substrate P, then there is a possibility that the light emergent surface 12 of the first optical element LS11 will deform, and that the first optical element LS11 will move in the Y axial directions, and there is a possibility that the optical characteristics of the first optical element LS11 will degrade.

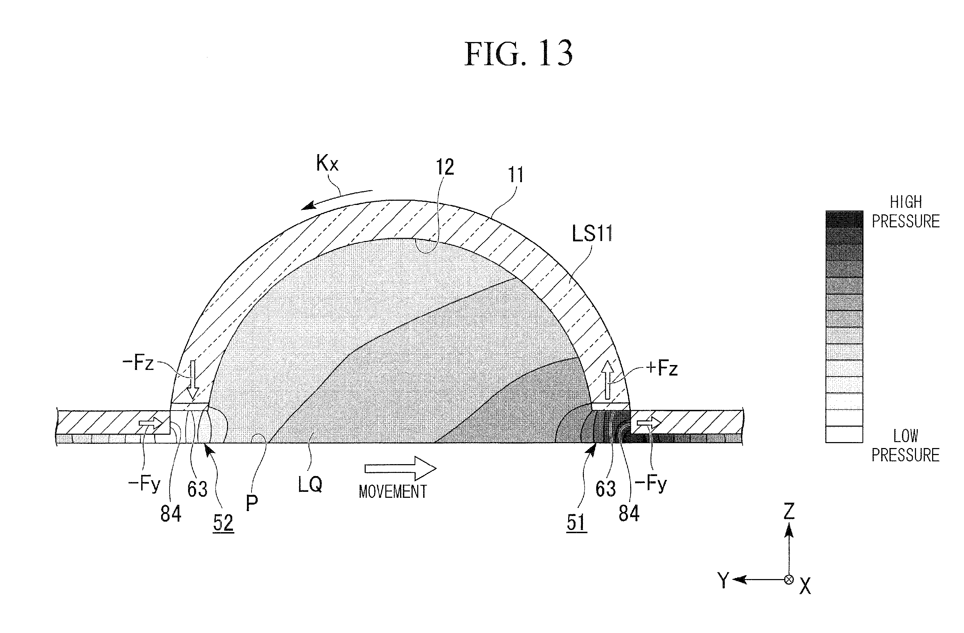

FIG. 13 shows the simulation result for a case wherein the first lower surface 63 and the side surface 84 are provided on the outer side of the light emergent surface 12 with respect to the optical axis AX. If the substrate P moves in the -Y direction with respect to the first optical element LS 11, then, as shown in FIG. 13, the liquid LQ pressure that acts upon the side surface 84 increases in the -Y direction. Namely, the movement of the substrate P in the -Y direction causes a strong liquid LQ force -Fy in the -Y direction to act upon the side surface 84. Meanwhile, the liquid LQ pressure that acts upon the light emergent surface 12 of the first optical element LS11 declines in the -Y direction. Thus, by providing the side surface 84, it is possible to reduce the pressure of the liquid LQ that acts upon the light emergent surface 12 in the -Y direction, and to also reduce the force of the liquid LQ that acts upon the light emergent surface 12. Because the side surface 84 that is subject to the liquid LQ force -Fy is the side surface of the second member 108, which is separate from the first member 61 that supports the first optical element LS11, it is possible to suppress the occurrence of problems, such as the unfortunate movement in the Y axial directions or the deformation of the first optical element LS11.

In addition, the provision of the side surface 84 raises the pressure in a space 51, which is surrounded by the first lower surface 63 and the side surface 84 on the -Y side with respect to the optical axis AX as well as by the front surface 10 of the substrate P, when the substrate P moves in the -Y direction. When the pressure of the space 51 rises, a force -Fy that acts upon the side surface 84 of the second member 108 in the -Y direction and a force +Fz that acts upon the first lower surface 63 in the +Z direction are generated. Meanwhile, when the substrate P moves in the -Y direction, the pressure of a space 52, which is surrounded by the first lower surface 63 and the side surface 84 on the +Y side with respect to the optical axis AX as well as by the front surface 10 of the substrate P, decreases; furthermore, a force -Fy that acts upon the side surface 84 of the second member 108 in the -Y direction and a force -Fz that acts upon the first lower surface 63 in the -Z direction are generated. The action of the force +Fz in the +Z direction upon the first lower surface 63 on the -Y side with respect to the optical axis AX and the action of the force -Fz in the -Z direction upon the first lower surface 63 on the +Y side with respect to the optical axis AX causes forces to act upon the first optical element LS11 in the θX directions. The support apparatus 6 rotatably supports the first optical element LS11 in directions (θX directions) about the axis G, which passes through the center of curvature C of the incident surface 11 and the light emergent surface 12, and the first optical element LS11 therefore rotates (refer to the arrow Kx) by the action of the +Fz, -Fz forces upon the first lower surface 63, with the center of curvature C as the center of rotation.

In the present embodiment, the incident surface 11 and the light emergent surface 12 of the first optical element LS11 are concentric spherical surfaces, and are constituted so that the support apparatus 6 rotates them, with the center of curvature C as the center of rotation. Accordingly, even though the first optical element LS 11 rotates with the center of curvature C as the center of rotation, its optical characteristics with respect to the exposure light EL do not substantially change.

In addition, because the side surface 84 is disposed so that the liquid LQ pressure that acts upon the light emergent surface 12 in the Y axial directions is less than the liquid LQ pressure that acts upon the first lower surface 63 in the Z axial directions, it is possible to reduce the liquid LQ pressure that acts upon the first optical element LS11 in the Y axial directions, and to smoothly rotate the first optical element LS 11 with the center of curvature C as the center of rotation.

Furthermore, the explanation herein was made by taking as an example a case wherein the substrate P moves in the -Y direction, but the same applies to a case wherein the substrate P moves in the +Y direction.

As explained above, making the incident surface 11 and the light emergent surface 12 of the first optical element LS11 substantially concentric and making the incident surface 11 and the light emergent surface 12 spherical surfaces, which are curved in a direction away from the substrate P, enables the optical characteristics of the first optical element LS11 to be maintained as well as the satisfactory exposure of the substrate P.

In addition, providing the first lower surface 63 so that it surrounds the light emergent surface 12, and providing the side surface 84 on the outer side of the first lower surface 63 with respect to the optical axis AX so that it faces the optical axis AX at a position that is closer to the front surface 10 of the substrate P than that of the first lower surface 63, makes it possible to reduce the force that acts upon the light emergent surface 12 of the first optical element LS11 in a prescribed direction. Accordingly, it is possible to maintain the optical characteristics of the first optical element LS11 and to satisfactorily expose the substrate P.

If the first optical element LS11 has a curved surface, then there is a possibility that it will become necessary to position the first optical element LS11 with high precision in order to maintain its optical characteristics, or that it will become difficult to maintain the state wherein the first optical element LS11 is positioned; however, in the present embodiment, the optical characteristics of the first optical element LS11 can be satisfactorily maintained.

<SIXTH EMBODIMENT>

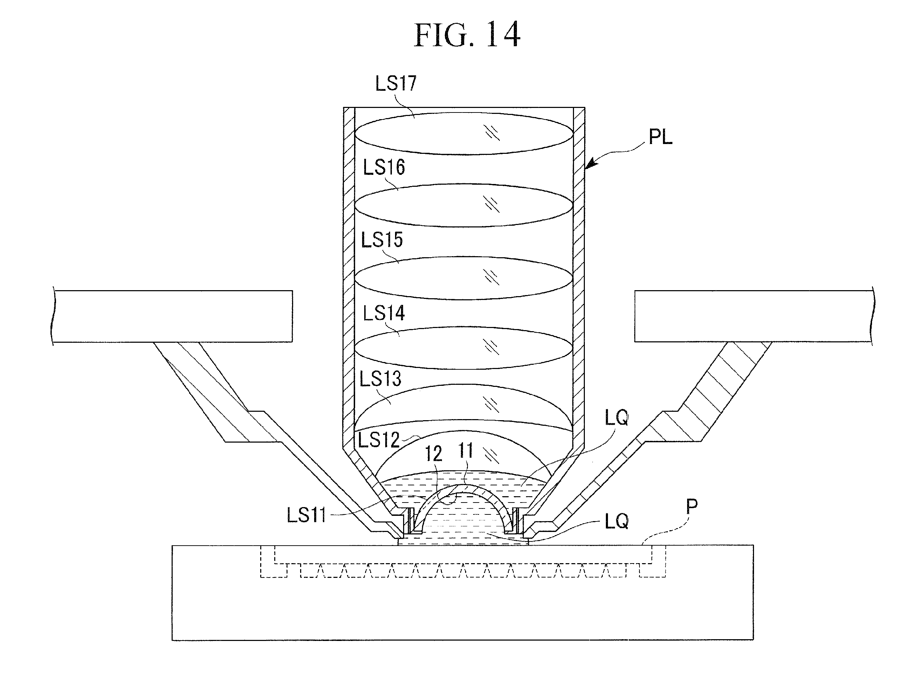

The sixth embodiment will now be explained, referencing FIG. 14. In the explanation below, constituent parts that are identical or equivalent to those in the embodiments discussed above are assigned identical symbols, and the explanations thereof are therefore abbreviated or omitted.

In FIG. 14, the liquid LQ is filled between the light emergent surface 12 of the first optical element LS11 and the front surface 10 of the substrate P, as well as between the first optical element LS11 and a second optical element LS 12 that, after the first optical element LS11, is the element that is closest to the image plane of the projection optical system PL. The type of liquid LQ that is filled between the light emergent surface 12 of the first optical element LS11 and the front surface 10 of the substrate P and the type of liquid LQ that is filled between the first optical element LS 11 and the second optical element LS12 may be the same or they may be different.

Thus, it is also possible for the liquid LQ to fill the exposure light optical path space that is between the first optical element LS11 and the second optical element LS12. In addition, filling the liquid LQ between the first optical element LS 11 and the second optical element LS12, makes it possible to permit a relatively low planar precision of, for example, the incident surface 11 of the first optical element LS11. Namely, if the medium that is filled between the first optical element LS11 and the second optical element LS12 is a gas, then there is a possibility that the difference between the refractive index of that medium (gas) with respect to the exposure light EL and the refractive index of the first optical element LS11 with respect to the exposure light EL will increase; however, making the medium that is filled between the first optical element LS 11 and the second optical element LS12 the liquid LQ enables a reduction in the difference between the refractive index of that medium (liquid LQ) with respect to the exposure light EL and the refractive index of the first optical element LS11 with respect to the exposure light EL. Accordingly, a somewhat low planar precision of the incident surface 11 of the first optical element LS11 can be permitted.

Furthermore, in the fifth and sixth embodiments discussed above, the first lower surface 63 is annularly formed so that it surrounds the light emergent surface 12 of the first optical element LS11; however, the first lower surface 63 may be provided only in directions (the Y axial directions in the embodiments discussed above) that allow the rotation of the first optical element LS11 with respect to the optical axis AX. In addition, the side surface 84 may also be provided only in a direction that is parallel to the movement directions of the substrate P.

Furthermore, in each of the embodiments discussed above, the side surface 84 is formed parallel to the Z axial directions, but it may be slightly inclined with respect to the Z axial directions.

Furthermore, in each of the embodiments discussed above, it was explained that the first lower surface 63 is formed in a member, such as the first member 61, that supports the first optical element LS11, but the first lower surface 63 may be formed in the first optical element LS 11. For example, the lower end surface 13 of the first optical element LS11 may serve as the first lower surface 63.

Furthermore, in each of the embodiments discussed above, the side surface 84 is formed in the second member 108, which is separate from the first optical element LS11 and the first member 61, but the side surface 84 may be formed in, for example, the first member 61. In addition, the side surface 84 may be formed in the first optical element LS11. In this case, by providing a mechanism (such as a cushioning mechanism or a vibration isolating mechanism) that, for example, reduces the liquid LQ force that acts upon the side surface 84, it is possible to reduce the impact of the force upon the first optical element LS11.

Furthermore, in each of the embodiments discussed above, the incident surface 11 and the light emergent surface 12 of the first optical element LS11 are spherical surfaces that have the same center of curvature C, but they may not necessarily be perfectly concentric spherical surfaces if the fluctuation of the optical characteristics of the first optical element LS 11 are within a permissible range when it rotates.

In addition, in each of the embodiments discussed above, increasing the amount of rotation of the first optical element LS11 makes it possible to reduce a change in the liquid LQ pressure in the spaces 51, 52, and to reduce the force that acts upon the object (e.g., the substrate P) that opposes the first optical element LS 11.

In addition, in each of the embodiments discussed above, the first optical element LS11 may be rotated by using a drive mechanism, such as an actuator. In this case, it is possible to perform feedback or feedforward control of the rotation of the first optical element LS11 in accordance with movement information (e.g., the movement directions) of the object that opposes the first optical element LS11. Information that can be used as the movement information of the object that opposes the first optical element LS 11 includes: the output of the laser interferometer 4L that acquires the positional information of the substrate stage 4; and the command information of the control apparatus 7 that controls the movement of the substrate stage 4.

Furthermore, in each of the embodiments discussed above, the interface LG of the liquid LQ, which forms the immersion region LR on the substrate P, is maintained between the second lower surface 83 and the front surface 10 of the substrate P, but it may be maintained between the first lower surface 63 and the front surface 10 of the substrate P.

Furthermore, in each of the embodiments discussed above, exposure is performed in a state wherein the liquid LQ is held between the first optical element LS 11 and the substrate P; however, a supply port that is capable of supplying the liquid LQ and a recovery port that is capable of recovering the liquid LQ may be provided in the vicinity of the optical path space K, and the substrate P may be exposed while exchanging the liquid LQ, which fills the optical path space K, by performing the supply port liquid supply operation and the recovery port liquid recovery operation in parallel.

Furthermore, in each of the embodiments discussed above, the immersion region LR of the liquid LQ is formed on the substrate P, but it can be formed on an object, such as the upper surface 4F of the substrate stage 4, that is capable of opposing the light emergent surface 12 of the first optical element LS11.

Furthermore, in each of the embodiments discussed above, ArF excimer laser light is used as the exposure light EL, but it is possible, as discussed above, to use various types of exposure light, such as $F_2$ laser light, and it is also possible to use a liquid as the liquid LQ, which fills the optical path space K, that is optimal with respect to, for example, the exposure light EL, the numerical aperture of the projection optical system PL, or the refractive index of the first optical element LS11 with respect to the exposure light EL.

In addition, in the embodiments discussed above, the liquid LQ used has a refractive index with respect to the exposure light EL that is higher than that of the first optical element LS11, but a liquid may be used for the liquid LQ that has a refractive index that is on the same order as or lower than that of the first optical element LS 11. The first optical element LS11, which is a spherical surface wherein the incident surface 11 and the light emergent surface 12 have the same center of curvature, as recited in the embodiments discussed above, is effective in the case wherein a liquid LQ is used that has a refractive index that is higher than that of the first optical element LS11; however, the present invention may be adapted to a case wherein a liquid LQ is used that has a refractive index on the same order or lower than that of the first optical element LS11.

Furthermore, each of the embodiments discussed above was explained by taking as an example a liquid immersion type exposure apparatus that fills the exposure light optical path space K with the liquid LQ, but the present invention can also be adapted to a normal dry type exposure apparatus, wherein the exposure light optical path space K is only filled with gas.

Furthermore, the substrate P in each of the abovementioned embodiments is not limited to a semiconductor wafer for fabricating semiconductor devices, and is also applicable to, for example, a glass substrate for a display device, a ceramic wafer for a thin film magnetic head, and a mask or the original plate of a reticle (synthetic quartz, silicon wafer) used by an exposure apparatus.

The exposure apparatus EX can also be adapted to a step-and-scan type scanning exposure apparatus (scanning stepper) that scans and exposes the pattern of the mask M by synchronously moving the mask M and the substrate P, as well as a step-and-repeat type projection exposure apparatus (stepper) that performs a full field exposure of the pattern of the mask M with the mask M and the substrate P in a stationary state, and sequentially steps the substrate P.

In addition, the exposure apparatus EX can also be adapted to an exposure apparatus that uses a projection optical system (e.g., a refraction type projection optical system, which does not include a reflecting element, with a 1/8 reduction magnification) to perform a full field exposure of a reduced image of a first pattern onto the substrate P in a state wherein the first pattern and the substrate P are substantially stationary. In this case, the exposure apparatus EX can also be adapted to a stitching type full field exposure apparatus that subsequently further uses that projection optical system to perform a full field expose of a reduced image of a second pattern, in a state wherein the second pattern and the substrate P are substantially stationary, onto the substrate P, so that it partially overlaps the first pattern. In addition, the stitching type apparatus can also be adapted to a step-and-stitch system exposure apparatus that transfers at least two patterns onto the substrate P so that they partially overlap, and sequentially steps the substrate P.

In addition, each of the abovementioned embodiments was explained by taking as an example an exposure apparatus provided with the projection optical system PL, but the present invention can be adapted to an exposure apparatus and an exposure method that does not use the projection optical system PL. Even if a projection optical system is not used, exposure light is radiated onto the substrate through optical members, such as a mask and a lens, and an immersion region is formed in a prescribed space between the substrate and such optical members.

In addition, the present invention can also be adapted to a twin stage type exposure apparatus that is provided with a plurality of substrate stages, as disclosed in, for example, Japanese Unexamined Patent Application, Publication No. H10-163099, Japanese Unexamined Patent Application, Publication No. H10-214783 (corresponding U.S. Patent No. 6,590,634), Published Japanese Translation No. 2000-505958 of the PCT International Publication (corresponding U.S. Patent No. 5,969,441), and U.S. Patent No. 6,208,407.

Furthermore, the present invention can also be adapted to an exposure apparatus that is provided with a substrate stage, which holds a substrate, and a measurement stage, on which various photoelectric sensors and/or a fiducial member, wherein a fiducial mark is formed, are installed, as disclosed in, for example, Japanese Unexamined Patent Application, Publication No. H11-135400 (corresponding PCT International Publication WO1999/23692), and Japanese Unexamined Patent Application, Publication No. 2000-164504 (corresponding U.S. Patent No. 6,897,963).

In addition, in the embodiments discussed above, the liquid that is filled between the projection optical system PL and the substrate P covers a local area of the front surface 10 of the substrate P; however, the present invention can also be adapted to a liquid immersion exposure apparatus that exposes the entire front surface of a substrate to be exposed in a state wherein the substrate is immersed in liquid, as disclosed in, for example, Japanese Unexamined Patent Application, Publication No. H6-124873, Japanese Unexamined Patent Application, Publication No. H10-303114, and U.S. Patent No. 5,825,043.

The type of exposure apparatus EX is not limited to a semiconductor device fabrication exposure apparatus that exposes the pattern of a semiconductor device on the substrate P, but can also be widely adapted to an exposure apparatus that is used for fabricating, for example, liquid crystal devices or displays, and an exposure apparatus that is used for fabricating thin film magnetic heads, imaging devices (CCDs), micromachines, MEMS, DNA chips, or reticles and masks.

Furthermore, in each of the abovementioned embodiments, the positional information of the mask stage 3 and the substrate stage 4 is measured using the interferometer systems (3L, 4L), but the present invention is not limited thereto and, for example, an encoder system may be used that detects a scale (diffraction grating) that is provided to each stage. In this case, the system is constituted as a hybrid system that is provided with both an interferometer system and an encoder system, and it is preferable to use the measurement results of the interferometer system to calibrate the measurement results of the encoder system. In addition, the position of the stages may be controlled by switching between the interferometer system and the encoder system, or by using both.

Furthermore, in the abovementioned embodiments, a light transmitting type mask is used wherein a prescribed shielding pattern (or a phase pattern and dimming pattern) is formed on a light transmitting substrate; however, instead of such a mask, it is also possible to use an electronic mask (also called a variable forming mask, including, for example, a digital micromirror device (DMD), which is one type of a non light emitting image display device, such as a spatial light modulator), wherein a transmittance pattern, a reflected pattern, or a light emitting pattern is formed based on electronic data of the pattern to be exposed, as disclosed in, for example, U.S. Patent No. 6,778,257.

In addition, by forming interference fringes on the substrate P, as disclosed in, for example, PCT International Publication WO2001/035168, the present invention can also be adapted to an exposure apparatus (lithographic system) that exposes the substrate P with a line-and-space pattern.

Furthermore, the present invention can also be adapted to an exposure apparatus that combines, through a projection optical system, the patterns of two masks on a substrate, and double exposes, substantially simultaneously, a single shot region on the substrate by a single scanning exposure, as disclosed in, for example, Published Japanese Translation No. 2004-519850 of the PCT International Publication (corresponding U.S. Patent No. 6,611,316).

As far as is permitted by the law of the countries specified or selected in this patent application, the disclosures in all of the Patent Publications and U.S. Patents related to exposure apparatuses and the like cited in the above respective embodiments and modified examples, are incorporated herein by reference.

As described above, the exposure apparatus EX of the embodiments in the present application is manufactured by assembling various subsystems, including each constituent element recited in the claims of the present application, so that prescribed mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus from the various subsystems includes the mutual mechanical connection of the various subsystems, the wiring and connection of electrical circuits, the piping and connection of the atmospheric pressure circuit, and the like. Naturally, before the process of assembling the exposure apparatus from these various subsystems, there are also the processes of assembling each individual subsystem. When the process of assembling the exposure apparatus from the various subsystems is finished, a comprehensive adjustment is performed to ensure the various accuracies of the exposure apparatus as a whole. Furthermore, it is preferable to manufacture the exposure apparatus in a clean room wherein, for example, the temperature and the cleanliness level are controlled.

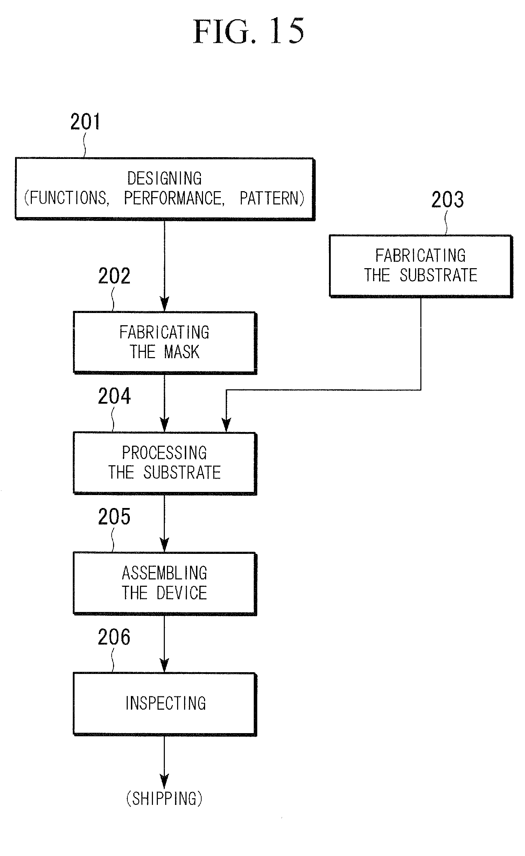

As shown in FIG. 15, a micro-device, such as a semiconductor device, is manufactured by, for example: a step 201 that designs the functions and performance of the micro-device; a step 202 that fabricates a mask (reticle) based on this designing step; a step 203 that fabricates a substrate, which is the base material of the device; a step 204 that includes substrate treatment processes, such as the process of exposing the pattern of the mask onto the substrate by using the exposure apparatus EX of the embodiments discussed above, a process that develops the exposed substrate, and a process that heats (cures) and etches the developed substrate; a device assembling step 205 (comprising fabrication processes, such as a dicing process, a bonding process, and a packaging process); and an inspecting step 206.

**Claims**

1. An exposure apparatus that exposes a substrate through an immersion region, comprising:

   an optical element that has a concave surface from which exposure light emerges; and a surface that is provided to surround an optical path of the exposure light, an interface of a liquid of the immersion region being held between the surface and an object, the object being disposed at a position where the object can be irradiated by the exposure light.

2. An exposure apparatus according to Claim 1, wherein at least one of a liquid immersion condition, which is for forming the immersion region, and a surface condition is set so that the interface of the liquid is held between the object and the surface by a surface tension of the liquid.

3. An exposure apparatus according to Claim 2, wherein at least one of the liquid immersion condition and the surface condition is set in accordance with an object front surface condition.

4. An exposure apparatus according to Claim 3, wherein the front surface condition of the object includes a contact angle condition of the liquid at the front surface of the object.

5. An exposure apparatus according to any one of Claims 2 to 4, wherein the surface condition includes at least one of a distance condition between the object and the surface, and the contact angle condition of the liquid at the surface.

6. An exposure apparatus according to any one of Claims 2 to 5, wherein the liquid immersion condition includes a condition related to at least one of a density of the liquid and an amount of the liquid.

7. An exposure apparatus according to Claim 6, wherein the condition related to the amount of the liquid includes at least one of a distance condition between the object and a position of the concave surface that is farthest from the object, and a condition related to the size of the immersion region in the radial direction.

8. An exposure apparatus according to any one of Claims 1 to 7, further comprising: an adjustment apparatus that adjusts a density of the liquid that is supplied between the concave surface and the object.

9. An exposure apparatus according to any one of Claims 1 to 8, wherein

the condition of $\rho \times g \times h < (\gamma \times (\cos\theta_1 + \cos\theta_2)/d) + (\gamma/R) + P_A$ is satisfied,
wherein
$\rho$: density of the liquid;
$g$: gravitational acceleration;
$h$: distance between the object and the position of the concave surface that is farthest from the object;
$\gamma$: surface tension of the liquid;
$\theta_1$ : contact angle of the front surface of the object with respect to the liquid;
$\theta_2$ : contact angle of the surface with respect to the liquid;
$d$: distance between the object and the surface;
$R$: radius of the immersion region; and
$P_A$: pressure of the surroundings of the immersion region.

10. An exposure apparatus according to any one of Claims 1 to 9, wherein the object includes the substrate.

11. An exposure apparatus according to any one of Claims 1 to 10, wherein the surface is part of a nozzle member that has at least one of a supply port that supplies the liquid and a recovery port that recovers the liquid.

12. An exposure apparatus according to any one of Claims 1 to 11, wherein the surface is part of a holding member that holds the optical element.

13. An exposure apparatus according to any one of Claims 1 to 12, wherein the surface is part of the optical element.

14. An exposure apparatus according to any one of Claims 1 to 13, wherein a refractive index of the liquid with respect to the exposure light is higher than that of the optical element with respect to the exposure light.

15. An exposure apparatus according to any one of Claims 1 to 14, further comprising:

a projection optical system that projects a pattern image onto the substrate; wherein,
the optical element that has the concave surface is an element of a plurality of optical elements of the projection optical system that is closest to an image plane of the projection optical system.

16. An exposure method, comprising:

forming an immersion region so that a space between an object and a concave surface of an optical element is filled with a liquid, an interface of the liquid being positioned between the object and a surface, the surface being provided to surround the optical path of exposure light; and exposing a substrate through the immersion region.

17. An exposure method according to Claim 16, wherein at least one of a object front surface condition, a surface condition, and a liquid immersion condition, which is for forming the immersion region, is set so that the interface of the liquid is positioned between the object and the surface by a surface tension of the liquid.

18. An exposure method according to Claim 16 or 17, wherein
the condition of $\rho \times g \times h < (\gamma \times (\cos\theta_1 + \cos\theta_2)/d) + (\gamma/R) + P_A$ is satisfied,
wherein
$\rho$: density of the liquid;
$g$: gravitational acceleration;
$h$: distance between the object and the position of the concave surface that is farthest from the object;
$\gamma$: surface tension of the liquid;
$\theta_1$ : contact angle of the front surface of the object with respect to the liquid;
$\theta_2$ : contact angle of the surface with respect to the liquid;
$d$: distance between the object and the surface;
$R$: radius of the immersion region; and
$P_A$: pressure of the surroundings of the immersion region.

19. An exposure method according to any one of Claims 16 to 18, wherein the object includes the substrate.

20. A device fabricating method, wherein an exposure method according to any one of Claims 16 to 19 is used.

21. An exposure apparatus that exposes a substrate by radiating exposure light onto the substrate, comprising:

a projection optical system that projects a pattern image onto the substrate and that comprises a first optical element, the first optical element having a first surface that the exposure light impinges and a second surface from which the exposure light emerges; wherein,
the first surface and the second surface are substantially concentric and are spherical surfaces; and
the first optical element is an element of a plurality of optical elements of the projection optical system that is closest to an image plane of the projection optical system.

22. An exposure apparatus according to Claim 21, further comprising: a support apparatus that rotatably supports the first optical element with a center of curvature of the first surface and the second surface as a center of rotation.

23. An exposure apparatus according to Claim 21, wherein the space between the substrate and the second surface of the first optical element is filled with a liquid through which the exposure light passes.

24. An exposure apparatus according to Claim 23, wherein a refractive index of the liquid with respect to the exposure light is higher than that of the first optical element with respect to the exposure light.

25. An exposure apparatus according to Claim 23 or 24, wherein a numerical aperture of the projection optical system is greater than a refractive index of the first optical element with respect to the exposure light.

26. An exposure apparatus according to any one of Claims 23 to 25, wherein the space between the first optical element and a second optical element that, after the first optical element, is the element that is closest to the image plane, is also filled with a liquid.

27. An exposure apparatus according to any one of Claims 23 to 26, wherein the substrate is exposed while moving the first optical element and the substrate relative to one another in a state wherein the liquid is filled between the second surface of the first optical element and the substrate.

28. An exposure apparatus according to any one of Claims 23 to 27, further comprising: a support apparatus that rotatably supports the first optical element with a center of curvature of the first surface and the second surface of the first optical element as a center of rotation.

29. An exposure apparatus according to Claim 28, wherein
the substrate is exposed while moving the first optical element and the substrate relative to one another in a first direction; and
the support apparatus rotatably supports the first optical element about an axis that passes through the center of curvature and that is parallel to a second direction, which intersects the first direction.

30. An exposure apparatus according to any one of Claims 23 to 29, further comprising:

a third surface that is disposed on the outer side of the second surface with respect to the optical axis of the first optical element; wherein,
the liquid is held between the second surface and the substrate, and between the substrate and at least part of the third surface.

31. An exposure apparatus according to Claim 30, wherein the third surface is provided to oppose the substrate front surface.

32. An exposure apparatus according to Claim 30 or 31, wherein the third surface is formed to be substantially perpendicular to the optical axis of the first optical element and to surround the second surface.

33. An exposure apparatus according to any one of Claims 30 to 32, further comprising: a fourth surface, which is provided on the outer side of the third surface with respect to the optical axis of the first optical element and that faces the optical axis.

34. An exposure apparatus according to Claim 33, wherein the fourth surface is provided at a position that is closer to the substrate front surface than that of the third surface.

35. An exposure apparatus according to Claim 33 or 34, wherein the fourth surface is provided in order to reduce the force of the liquid that acts upon the second surface of the first optical element.

36. An exposure apparatus according to any one of Claims 33 to 35, wherein the fourth surface is provided so that the pressure of the liquid that acts upon the second surface of the first optical element is smaller than the pressure of the liquid that acts upon the third surface.

37. An exposure apparatus according to any one of Claims 33 to 36, wherein a member that has the fourth surface is a member that is separate from the member that has the third surface.

38. An exposure apparatus according to any one of Claims 30 to 37, wherein a member that has the third surface includes a member that supports the first optical element.

39. An exposure apparatus that exposes a substrate by radiating exposure light onto the substrate, comprising:

an optical element that has a concave surface part from which the exposure light emerges;
a lower surface that is provided to surround the concave surface part; and
a side surface that is provided on the outer side of the lower surface with respect to the optical axis of the optical element and that faces the optical axis.

40. An exposure apparatus according to Claim 39, wherein
the concave surface part of the optical element is a curved surface that is concave in a direction away from the substrate;
a liquid is filled between the concave surface part and the substrate; and
the side surface is provided so that the pressure of the liquid that acts upon the concave surface part decreases in a direction that intersects the optical axis direction of the optical element.

41. An exposure apparatus according to Claim 40, wherein the side surface is provided so that the pressure of the liquid that acts upon the concave surface part in a direction that intersects the optical axis direction of the optical element falls below the pressure of the liquid that acts upon the lower surface in the optical axis direction of the optical element.

42. An exposure apparatus according to any one of Claims 39 to 41, further comprising:

a support member that supports the optical element; wherein,
the lower surface is formed in the optical element or the support member.

43. An exposure apparatus according to Claim 42, wherein the member that has the side surface is a member that is separate from the optical element and the support member.

44. An exposure method that exposes a substrate by radiating exposure light onto the substrate, comprising:

radiating the exposure light to an optical element, the optical element opposing a front surface of the substrate and having a concave surface part from which the exposure light emerges; and
irradiating the substrate with the exposure light in a state in which a liquid is filled between the concave surface part of the optical element and a front surface of the substrate; wherein
the liquid is contacted with a lower surface, which is provided to surround the concave surface part, and a side surface, which is provided on the outer side of the lower surface with respect to the optical axis of the optical element and that faces the optical axis.

45. An exposure method according to Claim 44, wherein the concave surface part of the optical element is a curved surface that is convex in a direction away from the substrate; and
the side surface is disposed so that the pressure of the liquid that acts upon the concave surface part decreases in a direction that intersects the optical axis direction of the optical element.

46. A device fabricating method, wherein an exposure method according to Claim 44 or 45 is used.

FIG. 1

EP 1 936 665 A1

# FIG. 2

# FIG. 3

SUBSTRATE FRONT SURFACE INFORMATION
(CONTACT ANGLE INFORMATION)

| 8 | | 7 |
|---|---|---|
| COATER APPARATUS | → | CONTROL APPARATUS |

ADJUSTMENT APPARATUS 9

LQ → TO OPTICAL PATH K

# FIG. 4

# FIG. 5

# FIG. 6

# FIG. 7

FIG. 8

FIG. 9A

FIG. 9B

FIG. 10

108

6

5

64

Kx

13

LS11

11

AX

12

Kx

13

64

108

60 61 84 63

83

LG

84 61 60 63

83

LQ(LR)

G(C)

P

Z
X
Y

# FIG. 11

# FIG. 12

EP 1 936 665 A1

FIG. 13

FIG. 14

# FIG. 15

201

DESIGNING
(FUNCTIONS, PERFORMANCE, PATTERN)

203

FABRICATING
THE SUBSTRATE

202

FABRICATING
THE MASK

204

PROCESSING
THE SUBSTRATE

205

ASSEMBLING
THE DEVICE

206

INSPECTING

(SHIPPING)

## INTERNATIONAL SEARCH REPORT

International application No.

PCT/JP2006/318645

### A. CLASSIFICATION OF SUBJECT MATTER
*H01L21/027*(2006.01)i

According to International Patent Classification (IPC) or to both national classification and IPC

### B. FIELDS SEARCHED

Minimum documentation searched (classification system followed by classification symbols)
H01L21/027

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | WO 2004/057590 A1 (Koninklijke Philips Electronics N.V.),<br>07 August, 2004 (07.08.04),<br>Page 8, line 8 to page 10, line 31;<br>Figs. 2, 3, 6<br>& EP 1584089 A1          & AT 335272 T<br>& JP 2006-511021 A | 1-2,10-17,<br>19,20<br>27,30-32,38 |
| X<br>Y | JP 2000-58436 A (Nikon Corp.),<br>25 February, 2000 (25.02.00),<br>Claims; Par. Nos. [0012] to [0014]; Figs. 1, 3<br>(Family: none) | 21,23-25<br>22,27-32,38 |
| X | JP 59-19912 A (Hitachi, Ltd.),<br>01 February, 1984 (01.02.84),<br>Claims; Fig. 1<br>(Family: none) | 1 |

| ☒ | Further documents are listed in the continuation of Box C. | ☐ | See patent family annex. |

\*    Special categories of cited documents:
"A"   document defining the general state of the art which is not considered   to be of particular relevance
"E"   earlier application or patent but published on or after the international filing date
"L"   document which may throw doubts on priority claim(s) or which is cited to establish the publication date of another citation or other special reason (as specified)
"O"   document referring to an oral disclosure, use, exhibition or other means
"P"   document published prior to the international filing date but later than the priority date claimed

"T"   later document published after the international filing date or priority date and not in conflict with the application but cited to understand the principle or theory underlying the invention
"X"   document of particular relevance; the claimed invention cannot be considered novel or cannot be considered to involve an inventive step when the document is taken alone
"Y"   document of particular relevance; the claimed invention cannot be considered to involve an inventive step when the document is combined with one or more other such documents, such combination being obvious to a person skilled in the art
"&"   document member of the same patent family

Date of the actual completion of the international search
20 December, 2006 (20.12.06)

Date of mailing of the international search report
09 January, 2007 (09.01.07)

Name and mailing address of the ISA/
Japanese Patent Office

Authorized officer

Facsimile No.

Telephone No.

Form PCT/ISA/210 (second sheet) (April 2005)

36

**INTERNATIONAL SEARCH REPORT**

International application No.

PCT/JP2006/318645

C (Continuation).　DOCUMENTS CONSIDERED TO BE RELEVANT

| Category* | Citation of document, with indication, where appropriate, of the relevant passages | Relevant to claim No. |
|---|---|---|
| Y | JP 2005-197690 A (International Business Machines Corp.), 21 July, 2005 (21.07.05), Claims; Figs. 1 to 6 & US 2005/145803 A1 　　& CN 1637612 A | 22,28,29 |
| A | JP 2005-209769 A (Canon Inc.), 04 August, 2005 (04.08.05), Full text; all drawings & US 2005/237502 A1 | 1-46 |
| A | JP 6-124873 A (Canon Inc.), 06 May, 1994 (06.05.94), Full text; all drawings (Family: none) | 1-46 |
| P,X | JP 2006-245590 A (ASML Netherlands B.V.), 14 September, 2006 (14.09.06), Claims; Par. Nos. [0027] to [0032]; Figs. 6, 7 & US 2006/197927 A1 | 1,2,10-17, 19,20,39-46 |
| P,X | WO 2006/041086 A1 (Nikon Corp.), 20 April, 2006 (20.04.06), Par. Nos. [0043], [0044], [0078], [0080], [0081]; Figs. 1, 6 & WO 2006/041083 A1 　　& JP 2006-140459 A & JP 2006-190971 A | 1,2,10-17, 19-21,23-25, 27,30-32,38 |
| P,X | JP 2006-108687 A (ASML Netherlands B.V.), 20 April, 2006 (20.04.06), Claims; Par. Nos. [0022] to [0036]; Figs. 1 to 7 & EP 1645911 A1 　　& CN 1758143 A & US 2006/077369 A1 　　& KR 20060052064 A | 1,2,10-17, 19,20 |

Form PCT/ISA/210 (continuation of second sheet) (April 2005)

## INTERNATIONAL SEARCH REPORT

| International application No. |
| --- |
| PCT/JP2006/318645 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
    The inventions of claims 1-20 have "a special technical feature" relating to a plane arranged to surround the optical path of the exposure light, wherein an interface of the liquid of the liquid immersion region is held between the object arranged at a position where the exposure light can be applied and the plane.
    The inventions of claims 21-38 have "a special technical feature" relating to that a first plane and a second plane are substantially coaxial and the first plane and the second plane are spherical planes and among optical elements of the projection optical system, a first optical element is nearest to the image plane of the projection optical system.  (Continued to extra sheet)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

| INTERNATIONAL SEARCH REPORT | International application No. |
|---|---|
| | PCT/JP2006/318645 |

Continuation of Box No.III of continuation of first sheet(2)

The inventions of claims 39-46 have "a special technical feature" relating to a side surface arranged outside the lower surface with respect to the optical axis of the optical element and directed toward the optical axis.

There is no technical relationship among those inventions involving one or more of the same or corresponding special technical features. Accordingly, the inventions are not so linked as to form a single general inventive concept.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005273738 A
- JP 2005327092 A
- WO 9949504 A
- WO 2005059617 A
- WO 2005059618 A
- JP H8130179 B
- US 6721034 B
- JP 2001510577 PCT
- WO 199928790 PCT
- WO 2005059617 PCT
- JP 2004289126 A
- US 20040207824 A
- JP H10163099 B
- JP H10214783 B
- US 6590634 B
- JP 2000505958 PCT
- US 5969441 A
- US 6208407 B
- JP H11135400 B
- WO 199923692 PCT
- JP 2000164504 A
- US 6897963 B
- JP H6124873 B
- JP H10303114 B
- US 5825043 A
- US 6778257 B
- WO 2001035168 A
- JP 2004519850 PCT
- US 6611316 B